# EUROPEAN PATENT SPECIFICATION

(11) **EP 2 903 048 B1**
(45) Date of publication and mention of the grant of the patent: **10.01.2018**
(21) Application number: 13841725.8
(22) Date of filing: 25.09.2013
(51) Int. Cl.: H01L 51/50, C07F 5/02, C09K 11/06

(54) **COMPOUND FOR ORGANIC ELECTROLUMINESCENT ELEMENTS, AND ORGANIC ELECTROLUMINESCENT ELEMENT**
VERBINDUNG FÜR ORGANISCHE ELEKTROLUMINESZENZELEMENTE UND ORGANISCHES ELEKTROLUMINESZENZELEMENT
COMPOSÉ POUR ÉLÉMENTS ÉLECTROLUMINESCENTS ORGANIQUES, ET ÉLÉMENT ÉLECTROLUMINESCENT ORGANIQUE

(30) Priority: 28.09.2012 JP 2012216564
(43) Date of publication of application: 05.08.2015
(73) Proprietor: Nippon Steel & Sumikin Chemical Co., Ltd., Chiyoda-ku Tokyo 101-0021 (JP)
(72) Inventor: SANNOMIYA, Rumi, Kitakyushu-shi Fukuoka 804-8503 (JP); KAI, Takahiro, Kitakyushu-shi Fukuoka 804-8503 (JP); KOMORI, Masaki, Kitakyushu-shi Fukuoka 804-8503 (JP); YAMAMOTO, Toshihiro, Tokyo 101-0021 (JP); TADA, Masashi, Kitakyushu-shi Fukuoka 804-8503 (JP)
(74) Representative: Vossius & Partner Patentanwälte Rechtsanwälte mbB
(86) International application number: PCT/JP2013/075937
(87) International publication number: WO 2014/050904

(56) References cited:
- WO-A1-2011/125020
- WO-A1-2012/067425
- WO-A1-2013/002053
- WO-A1-2013/088934
- JP-A- 2012 140 367
- KR-A- 20100 131 939
- KR-A- 20110 011 578
- KR-A- 20120 013 278
- DATABASE CA [Online] CHEMICAL ABSTRACTS SERVICE, COLUMBUS, OHIO, US; XP002756267, Database accession no. 154:121059
- DATABASE CA [Online] CHEMICAL ABSTRACTS SERVICE, COLUMBUS, OHIO, US; XP002756268, Database accession no. 156:574103
- DATABASE CA [Online] CHEMICAL ABSTRACTS SERVICE, COLUMBUS, OHIO, US; XP002756269, Database accession no. 156:574104

## Description

### Technical Field

The present invention relates to a novel compound for an organic electroluminescent device and an organic electroluminescent device using the compound, and more specifically, to a thin-film-type device that emits light when an electric field is applied to a light-emitting layer formed of an organic compound.

### Background Art

In general, an organic electroluminescent device (hereinafter referred to as organic EL device) is constructed of a light-emitting layer and a pair of counter electrodes interposing the light-emitting layer therebetween in its simplest structure. That is, the organic EL device uses the phenomenon that, when an electric field is applied between both the electrodes, electrons are injected from a cathode and holes are injected from an anode, and each electron and each hole recombine in the light-emitting layer to emit light.

In recent years, progress has been made in developing an organic EL device using an organic thin film. In order to enhance luminous efficiency particularly, the optimization of the kind of electrodes has been attempted for the purpose of improving the efficiency of injection of carriers from the electrodes . Asaresult, there has been developed a device in which a hole-transporting layer formed of an aromatic diamine and a light-emitting layer formed of an 8-hydroxyquinoline aluminum complex (hereinafter referred to as Alq3) are formed between electrodes as thin films, resulting in a significant improvement in luminous efficiency, as compared to related-art devices in which a single crystal of anthracene or the like is used. Thus, the development of the above-mentioned organic EL device has been promoted in order to accomplish its practical application to a high-performance flat panel having features such as self-luminescence and rapid response.

Further, studies have been made on using phosphorescent light rather than fluorescent light as an attempt to raise the luminous efficiency of a device. Many kinds of devices including the above-mentioned device in which a hole-transporting layer formed of an aromatic diamine and a light-emitting layer formed of Alq3 are formed emit light by using fluorescent light emission. However, by using phosphorescent light emission, that is, by using light emission from a triplet excited state, luminous efficiency is expected to be improved by from about three times to four times, as compared to the case of using related-art devices in which fluorescent light (singlet) is used. In order to accomplish this purpose, studies have been made on adopting a coumarin derivative or a benzophenone derivative as a light-emitting layer, but extremely low luminance has only been provided. Further, studies have been made on using a europium complex as an attempt to use a triplet state, but highly efficient light emission has not been accomplished. In recent years, many studies on a phosphorescent light-emitting dopant material centered on an organic metal complex such as an iridium complex have been made, as described in Patent Literature 1, for the purpose of attaining high luminous efficiency and a long lifetime.

### Citation List

Patent Literature

[PTL 1] WO 01/041512 A
[PTL 2] JP 2001-313178 A
[PTL 3] JP 11-162650 A
[PTL 4] JP 11-176578 A
[PTL 5] WO 2008/056746 A
[PTL 6] WO 2008/146839 A
[PTL 7] WO 2010/114243 A

In order to obtain high luminous efficiency, host materials that are used with the dopant materials described above play an important role. A typical example of the host materials proposed is 4,4'-bis(9-carbazolyl)biphenyl (hereinafter referred to as CBP) as a carbazole compound disclosed in Patent Literature 2. When CBP is used as a host material for a green phosphorescent light-emitting material typified by a tris (2-phenylpyridine) iridium complex (hereinafter referred to as Ir(ppy)₃), the injection balance between charges is disturbedbecause CBP has the characteristic of facilitating the delivery of holes and not facilitating the delivery of electrons. Thus, excessively delivered holes flow out into an electron-transporting layer side, with the result that the luminous efficiency from Ir(ppy)₃ lowers.

In order to provide high luminous efficiency to an organic EL device as described above, it is necessary to use a host material that has high triplet excitation energy, and is striking a good balance in both charge (hole and electron)-injecting/transporting property. Further desired is a compound that has electrochemical stability, has high heat resistance, and has excellent amorphous stability, and hence further improvement has been demanded.

Patent Literature 3 discloses an indolocarbazole compound having a diphenylamino group as a hole-transporting material. Patent Literature 4 discloses a diphenylindolocarbazole compound as a hole-transporting material. Patent Literature 5 and Patent Literature 6 disclose nitrogen-containing heterocyclic group-substituted indolocarbazole compounds having a substituent as phosphorescent host materials, and disclose that organic EL devices using the compounds are improved in luminous efficiency and have high driving stability.

Each of Patent Literatures 1 to 6 discloses that a compound having an indolocarbazole skeleton is used in an organic EL device, but none of the literatures discloses a compound having a boron-containing group on an indolocarbazole skeleton. In addition, Patent Literature 7 teaches a compound obtained by substituting a fused five-membered ring with various substituents but does not teach any compound having a boron-containing group on an indolocarbazole skeleton.

WO2011/125020 and JP2012140367 disclose substituted carbazole derivatives for use in organic electronics.

### Summary of Invention

In order to apply an organic EL device to a display device in a flat panel display or the like, it is necessary to improve the luminous efficiency of the device and also to ensure sufficiently the stability in driving the device at a low driving voltage or the like. The present invention has an object to provide, in view of the above-mentioned circumstances, an organic EL device that has high efficiency, has high luminance stability when driven, and is practically useful and a compound suitable for the organic EL device.

The inventors of the present invention have made intensive studies and have consequently found that, when a compound having an indolocarbazole skeleton with a specific structure is used in an organic EL device, the organic EL device exhibits excellent characteristics. As a result, the present invention has been completed.

A compound for an organic EL device of the present invention is represented by the following general formula (1).

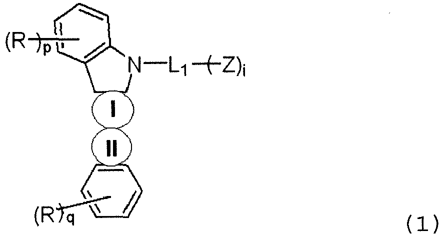

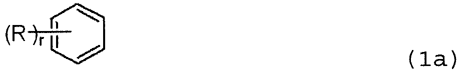

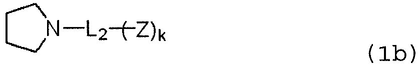

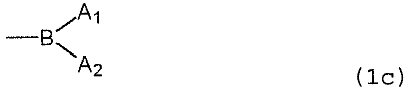

In the general formula (1), a ring I represents an aromatic hydrocarbon ring represented by the formula (1a) to be fused to adjacent rings at arbitrary positions, and a ring II represents a heterocycle represented by the formula (1b) to be fused to adjacent rings at arbitrary positions.

In the general formula (1) and the formula (1b), L₁ and L₂ each independently represent a substituted or unsubstituted aromatic hydrocarbon group having 6 to 18 carbon atoms, a substituted or unsubstituted aromatic heterocyclic group having 3 to 17 carbon atoms, or a linked aromatic group formed by linking two to six of the substituted or unsubstituted aromatic rings, the linked aromatic group may be linear or branched, and the aromatic rings to be linked may be identical to or different from each other. Further, L₁ represents an i+1-valent group and L₂ represents a k+1-valent group.

In the general formula (1) and the formula (1b), Z represents a boron-containing group represented by the formula (1c), and in the formula (1c), A₁ and A₂ each independently represent hydrogen, deuterium, an alkyl group having 1 to 12 carbon atoms, an alkenyl group having 2 to 12 carbon atoms, an alkynyl group having 2 to 12 carbon atoms, an alkoxyl group having 1 to 12 carbon atoms, chlorine, bromine, fluorine, a substituted or unsubstituted aromatic hydrocarbon group having 6 to 18 carbon atoms , or a substituted or unsubstituted aromatic heterocyclic group having 3 to 17 carbon atoms, and A₁ and A₂ may be bonded to adjacent A₁ and A₂ or substituents of A₁ and A₂ to form a ring.

In the general formula (1) and the formula (1a), Rs each independently represent deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group having 2 to 12 carbon atoms, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, an amide group, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c).

In the general formula (1), p and q each independently represent an integer of from 0 to 4, and in the formula (1a), r represents an integer of from 0 to 2. In the general formula (1) and the formula (1b), i and k each represent an integer of from 0 to 5, provided that p+q+r+i+k≥1 and when both of i and k represent 0, at least one of Rs represents a boron-containing group represented by the formula (1c), and when p, q, r, i, and k each represent 2 or more, Rs and Zs may be identical to or different from each other.

Examples of the compound for an organic EL device represented by the general formula (1) include compounds represented by the following general formulae (2) to (5). 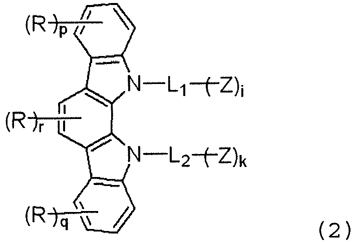 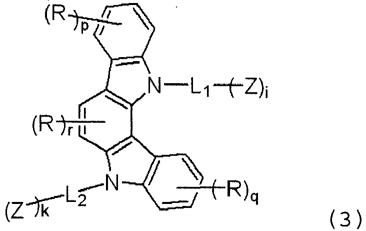 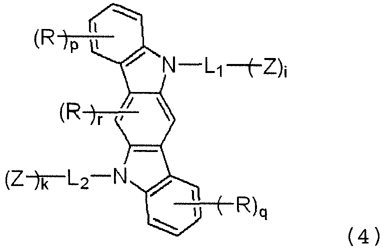 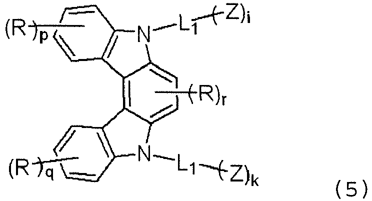 In the general formulae (2) to (5), L₁, L₂, Z, R, p, q, r, i, and k each have the same meaning as that of the general formula (1) .

In the general formulae (1) to (5) and the formula (1a), it is preferred that Rs each independently represent deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a dialkylamino group having 2 to 24 carbon atoms, a diarylamino group having 6 to 36 carbon atoms, a diaralkylamino group having 14 to 38 carbon atoms, an acyl group having 2 to 12 carbon atoms, an alkoxycarbonyl group having 2 to 12 carbon atoms, an alkoxyl group having 1 to 12 carbon atoms, an alkylsulfonyl group having 1 to 12 carbon atoms, a haloalkyl group having 1 to 12 carbon atoms, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c).

In the formula (1c), it is preferred that A₁ and A₂ each independently represent an alkyl group having 1 to 12 carbon atoms, a substituted or unsubstituted aromatic hydrocarbon group having 6 to 18 carbon atoms, or a substituted or unsubstituted aromatic heterocyclic group having 3 to 17 carbon atoms, and it is more preferred that A₁ and A₂ each independently represent a substituted or unsubstituted aromatic hydrocarbon group having 6 to 18 carbon atoms, or a substituted or unsubstituted aromatic heterocyclic group having 3 to 17 carbon atoms.

In addition, it is preferred that in each of the general formulae (1) to (5), i+k≥1 and Rs not represent boron-containing groups each represented by the formula (1c).

In addition, the present invention relates to an organic EL device including an organic layer containing the compound for an organic EL device. The organic layer is preferably at least one layer selected from a light-emitting layer, a hole-transporting layer, a hole-injecting layer, an electron-transporting layer, and an electron-injecting layer. It is more preferred that the light-emitting layer contain a phosphorescent light-emitting dopant and the compound for an organic EL device represented by any one of the general formulae (1) to (5) as a host material.

### Effects of Invention

The indolocarbazole compound for an organic EL device of the present invention has at least one boron-containing group in a molecule of the indolocarbazole compound. A boron atom of the boron-containing group has an unoccupied orbital on its molecular orbital, and hence the group has a low lowest unoccupied molecular orbital (LUMO) energy level and has a characteristic by which an energy gap with respect to the valence band of a cathode is reduced. Accordingly, the use of the compound of the present invention in an organic EL device can be expected to exhibit an effect by which charge-injecting/transporting properties are improved and hence the voltage of the organic EL device is reduced.

Because of the foregoing, the organic EL device using the indolocarbazole compound can realize a carrier balance optimum for various dopants in its light-emitting layer. As a result, an organic EL device significantly improved in light-emitting characteristics can be provided. Further, the indolocarbazole compound can improve stability in each of active states, i.e., oxidation, reduction, and excitation, and at the same time, has a good amorphous characteristic. Accordingly, the compound can realize an organic EL device that can be driven at a low voltage and has high durability.

### Brief Description of Drawings

FIG. 1 is a sectional view illustrating a structure example of an organic EL device.
FIG. 2 shows the ¹H-NMR chart of Compound B9 for an organic EL device of the present invention.

### Description of Embodiments

A compound for an organic EL device of the present invention is represented by the general formula (1).

In the general formula (1), a ring I represents an aromatic hydrocarbon ring represented by the formula (1a) to be fused to adjacent rings at arbitrary positions, and a ring II represents a heterocycle represented by the formula (1b) to be fused to adjacent rings at arbitrary positions.

In the indolocarbazole skeleton represented by the general formula (1), the aromatic hydrocarbon ring represented by the formula (1a) may be fused with two adjacent rings at arbitrary positions, but there is a position at which the aromatic hydrocarbon ring cannot be fused with the rings from the structural viewpoint. The aromatic hydrocarbon ring represented by the formula (1a) has six sides, and is not fused with the two adjacent rings through two adjacent sides. Further, the heterocycle represented by the formula (1b) may be fused with two adjacent rings at arbitrary positions, but there is a position at which the heterocycle cannot be fused with the rings from the structural viewpoint. That is, the heterocycle represented by the formula (1b) has five sides, and is not fused with the two adjacent rings through two adjacent sides and is not fused with an adjacent ring through a side including a nitrogen atom. Thus, there is a limitation on the kind of the indolocarbazole skeleton.

The general formula (1), the indolocarbazole skeleton is preferably represented by any one of the following structures. Preferred fusion positions of the aromatic hydrocarbon ring and the heterocycle in the indolocarbazole skeleton are understood from these examples.

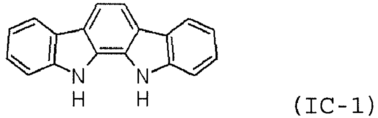

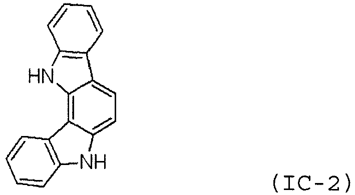

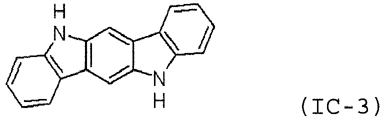

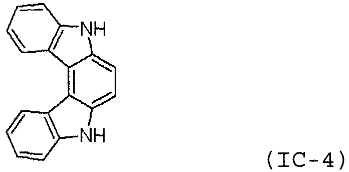

In the general formula (1), L₁ represents an i+1-valent group, and L₂ represents a k+1-valent group. L₁ and L₂ each independently represent a substituted or unsubstituted aromatic hydrocarbon group having 6 to 18 carbon atoms, a substituted or unsubstituted aromatic heterocyclic group having 3 to 17 carbon atoms, or a linked aromatic group in which two to six of aromatic rings of the aromatic hydrocarbon groups or the aromatic heterocyclic groups are linked, preferably a substituted or unsubstituted aromatic hydrocarbon group having 6 to 12 carbon atoms, a substituted or unsubstituted aromatic heterocyclic group having 3 to 12 carbon atoms, or a substituted or unsubstituted linked aromatic group produced by linking two to six of the substituted or unsubstituted aromatic rings. In the case of the linked aromatic group, the group may be linear or branched, and the aromatic rings to be linked may be identical to or different from each other.

Specific examples of the case where L₁ and L₂ each represent an unsubstituted aromatic hydrocarbon group, aromatic heterocyclic group, or linked aromatic group in which two to six of the substituted or unsubstituted aromatic rings are linked include: a group produced by removing i+1 or k+1 hydrogen atoms from an aromatic compound such as benzene, pentalene, indene, naphthalene, anthracene, phenanthrene, pyrrole, imidazole, pyrazole, thiazole, thiophene, pyridine, pyrazine, pyrimidine, pyridazine, triazine, isoindole, indazole, purine, benzimidazole, indolizine, chromene, benzoxazole, isobenzofuran, quinolizine, isoquinoline, imidazole, naphthyridine, phthalazine, quinazoline, quinoxaline, cinnoline, quinoline, pteridine, perimidine, phenanthroline, phenanthridine, acridine, phenazine, phenothiazine, phenoxazine, phenazasiline, dibenzodioxin, carboline, indole, indoloindole, carbazole, furan, benzofuran, isobenzofuran, benzothiazole, oxanthrene, dibenzofuran, thiophene, thioxanthene, thianthrene, phenoxathiin, thionaphthene, isothianaphthene, thiophthene, thiophanthrene, or dibenzothiophene; and a group produced byremoving i+1 or k+1 hydrogen atoms from an aromatic compound in which two to six of such groups are linked.

As a substituent in the case where L₁ and L₂ each represent an aromatic hydrocarbon group having a substituent, an aromatic heterocyclic group having a substituent, or a linked aromatic group having a substituent, there is given deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, an amide group, a phenoxy group, or an alkylthio group having 1 to 12 carbon atoms.
Of those, the following substituent is preferred: deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a dialkylamino group having 2 to 24 carbon atoms, a diarylamino group having 6 to 36 carbon atoms, a diaralkylamino group having 14 to 38 carbon atoms, an acyl group having 2 to 12 carbon atoms, an alkoxycarbonyl group having 2 to 12 carbon atoms, an alkoxyl group having 1 to 12 carbon atoms, an alkylsulfonyl group having 1 to 12 carbon atoms, a haloalkyl group having 1 to 12 carbon atoms, a phenoxy group, or an alkylthio group having 1 to 12 carbon atoms.

Here, when L₁ and L₂ each represent an unsubstituted monovalent linked aromatic group, examples of the structure of the linked aromatic group include such structures as represented by the following formulae (6) to (8). It should be noted that when i or k represents 1 or more, structures each produced by removing i or k hydrogen atoms from any one of those structures are adopted.

-**Ar**₁**-Ar**₂-**Ar**₃ (6)

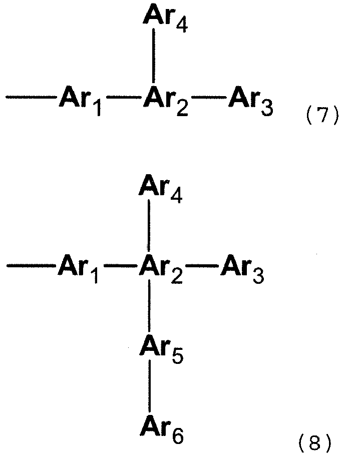

In the formulae (6) to (8), Ar₁ to Ar₆ each represent an unsubstituted monocyclic or fused aromatic ring, and may be identical to or different from one another.

Specific examples of the case where L₁ and L₂ each represent an unsubstituted linked aromatic group, and the case where L₁ and L₂ are each represented by any one of the formulae (6) to (8) include such groups as shown below and groups each produced by removing i or k hydrogen atoms from any one of these groups.

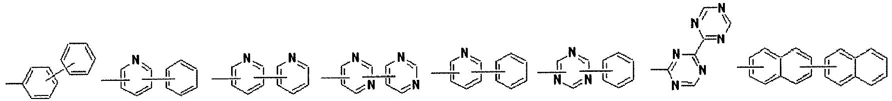

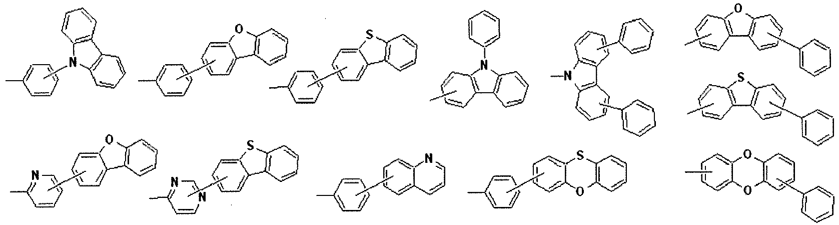

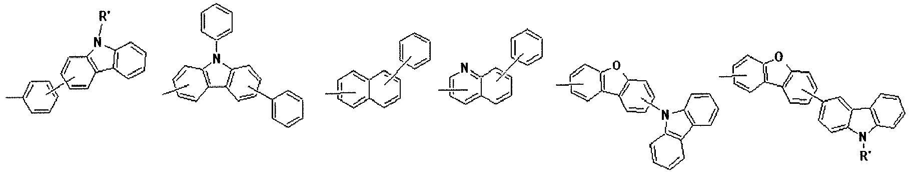

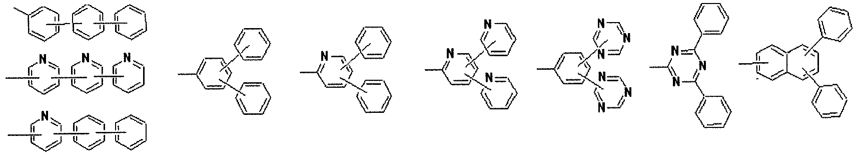

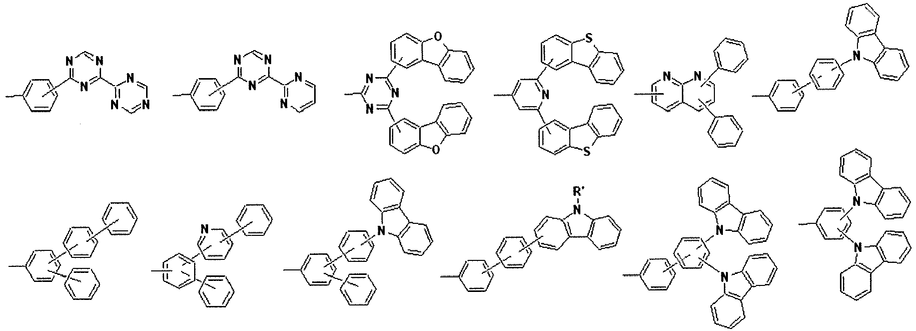

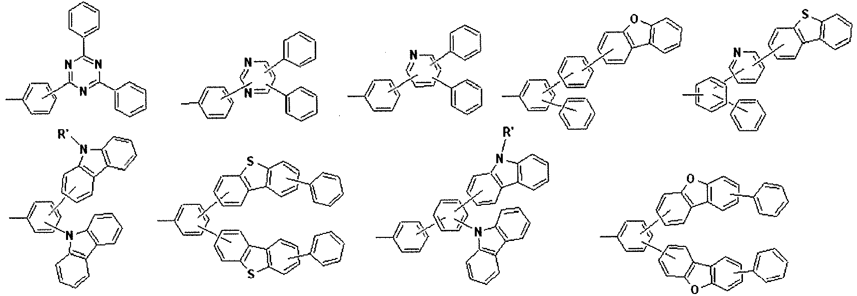

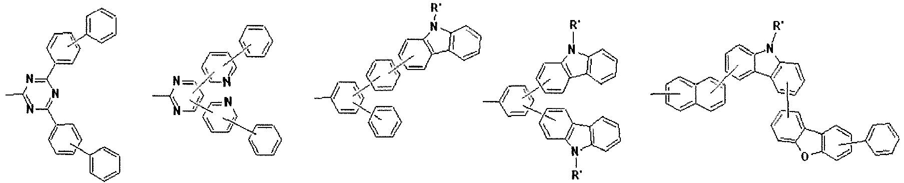

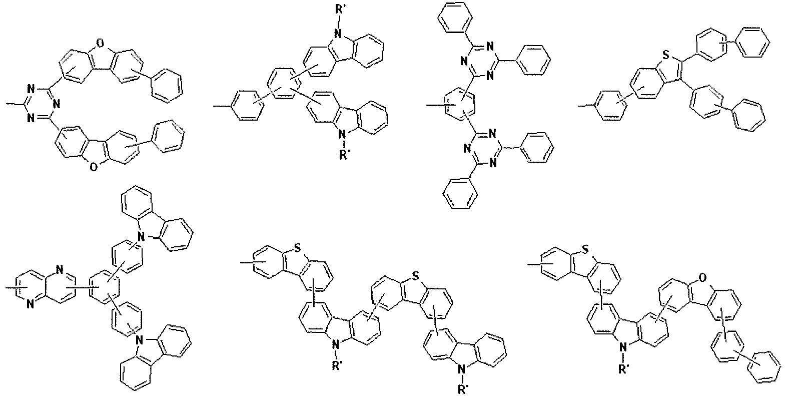

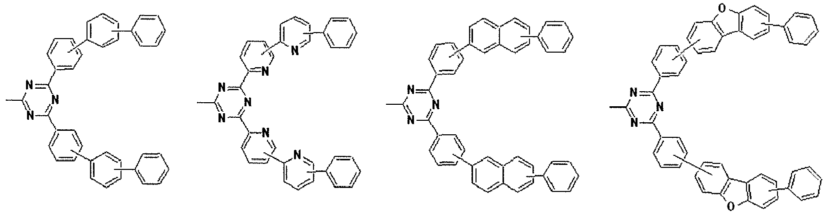

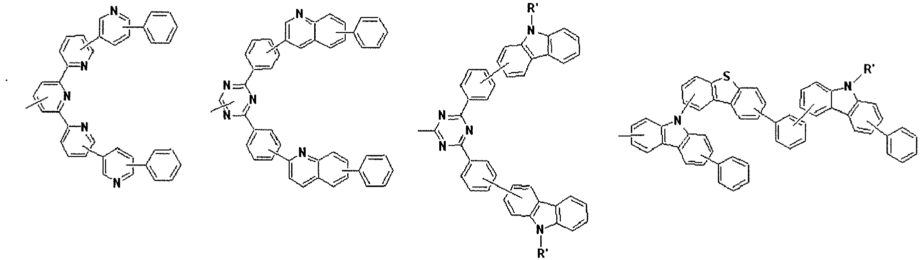

In the formulae, R' represents an aromatic hydrocarbon group having 6 to 18 carbon atoms or an aromatic heterocyclic group having 3 to 17 carbon atoms. Specific examples of the aromatic hydrocarbon group and the aromatic heterocyclic group are the same as those described for L₁ and L₂ in the general formula (1) except that the valence of each of the examples is one.

In the general formula (1) and the formula (1b), Z represents a boron-containing group represented by the formula (1c).

In the formula (1c), A₁ and A₂ each independently represent hydrogen, deuterium, an alkyl group having 1 to 12 carbon atoms, an alkenyl group having 2 to 12 carbon atoms, an alkynyl group having 2 to 12 carbon atoms, an alkoxyl group having 1 to 12 carbon atoms, chlorine, bromine, fluorine, a substituted or unsubstituted aromatic hydrocarbon group having 6 to 18 carbon atoms, or a substituted or unsubstituted aromatic heterocyclic group having 3 to 17 carbon atoms, preferably a substituted or unsubstituted aromatic hydrocarbon group having 6 to 18 carbon atoms, or a substituted or unsubstituted aromatic heterocyclic group having 3 to 17 carbon atoms. In addition, when A₁ and A₂ each represent an aromatic hydrocarbon group or an aromatic heterocyclic group, the groups may be bonded to each other to form a ring. For example, the two aromatic rings may be bonded to form a ring together with B. Further, substituents of the two aromatic rings may be bonded to each other to form a ring. In addition, one aromatic ring and a substituent of the other aromatic ring may be bonded to form a ring.

A substituent in the case where A₁ and A₂ each represent an aromatic hydrocarbon group having a substituent or an aromatic heterocyclic group having a substituent is deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, chlorine, bromine, fluorine, an amide group, a phenoxy group, an alkylthio group having 1 to 12 carbon atoms, an aromatic hydrocarbon group having 6 to 18 carbon atoms, or an aromatic heterocyclic group having 3 to 17 carbon atoms. Of those, the following substituent is preferred: deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, an aromatic hydrocarbon group having 6 to 18 carbon atoms, or an aromatic heterocyclic group having 3 to 17 carbon atoms.

In the general formula (1), the formula (1a), and the formula (1b), Rs each independently represent deuterium, an alkyl group having 1 to 12 carbon atoms, an aralkyl group having 2 to 12 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group having 2 to 12 carbon atoms, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, an amide group, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c), preferably deuterium, an alkyl group having 1 to 12 carbon atoms, a cycloalkyl group having 3 to 10 carbon atoms, a substituted or unsubstituted aromatic hydrocarbon group having 6 to 12 carbon atoms, a substituted or unsubstituted aromatic heterocyclic group having 3 to 12 carbon atoms, or a boron-containing group. The substituent in the case where Rs each represent an aromatic hydrocarbon group having a substituent or an aromatic heterocyclic group having a substituent has the same meaning as the substituent in the case where A₁ and A₂ each represent an aromatic hydrocarbon group having a substituent or an aromatic heterocyclic group having a substituent.

In the general formula (1), the formula (1a), and the formula (1b), p and q each independently represent an integer of from 0 to 4, r represents an integer of from 0 to 2, and i and k each represent an integer of from 0 to 5. It is preferred that p, q, r, i, and k each independently represent 0 or 1.

Here, p+q+r+i+k≥1 and at least one boron-containing group represented by the formula (1c) is present in the general formula (1) . It is preferred that i+k be 1 or more and Rs each represent a group except a boron-containing group represented by the formula (1c). When p, q, r, i, and k each represent 2 or more, Rs and Zs may be identical to or different from each other.

Preferred examples of the indolocarbazole compound represented by the general formula (1) include indolocarbazole compounds each represented by any one of the general formulae (2) to (5). In the general formulae (2) to (5), symbols common to the general formula (1), the formula (1a), the formula (1b), and the formula (1c) each have the same meaning.

A skeleton represented by any one of the formulae (IC-1) to (IC-4) is available as a preferred skeleton of the indolocarbazole compound represented by the general formula (1). The general formula (1) is a concept comprehending the skeletons represented by the formulae (IC-1) to (IC-4), and these skeletons can be described by taking the compound represented by the general formula (1) as a typical example.

Such skeletons as represented in the forms of the formulae (IC-1) to (IC-4) are each conceivable as the skeleton of the indolocarbazole compound represented by the general formula (1), and these skeletons can each be synthesized by employing a known approach from a raw material selected in accordance with the structure of a target compound.

For example, the indolocarbazole skeleton represented by the formula (IC-1) can be synthesized by the following reaction formula with reference to a synthesis example described in Synlett, 2005, No. 1, p42-48.

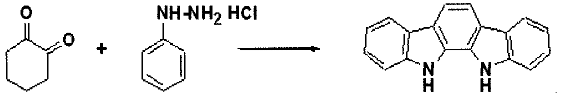

Further, the indolocarbazole skeleton represented by the formula (IC-3) can be synthesized by the following reaction formula with reference to a synthesis example described in Archiv der Pharmazie (Weinheim, Germany) 1987, 320(3), p280-2.

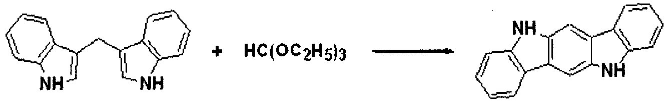

Specific examples of the indolocarbazole compound represented by the general formula (1) are shown below. However, the material for an organic EL device of the present invention is not limited thereto.

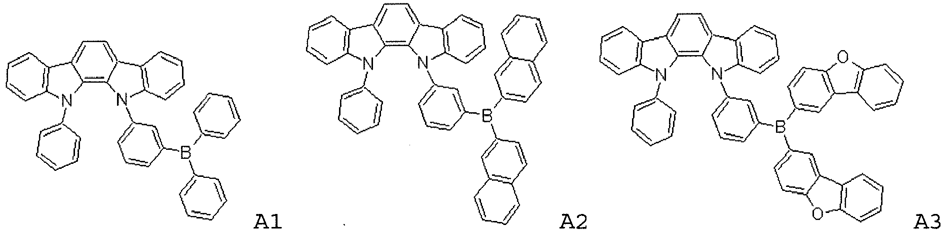

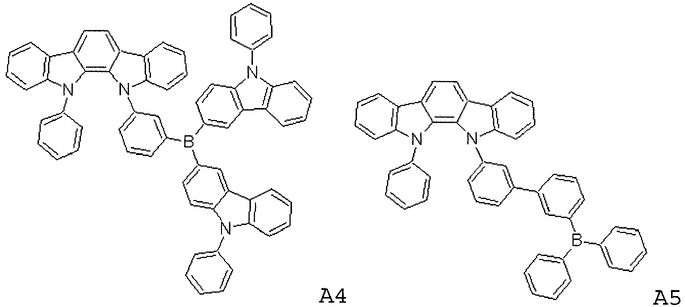

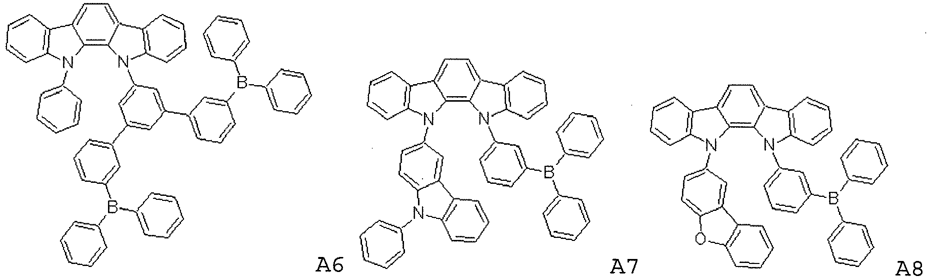

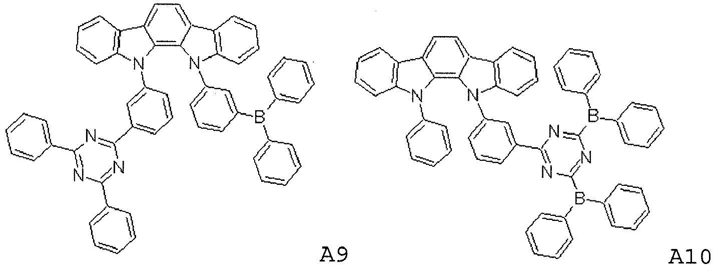

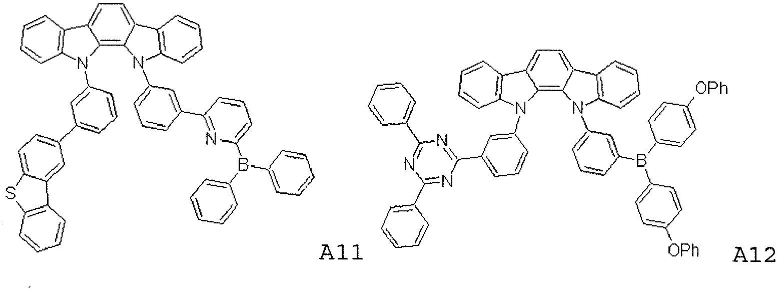

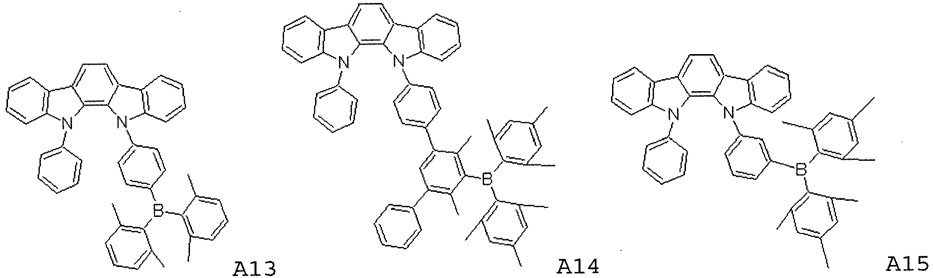

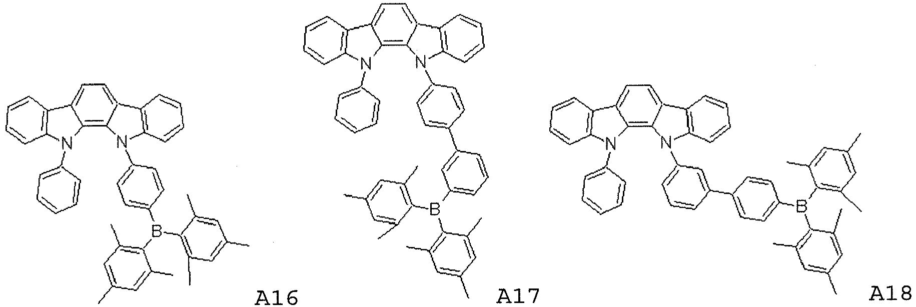

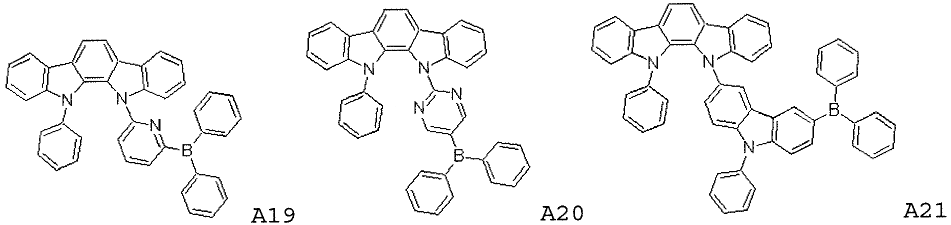

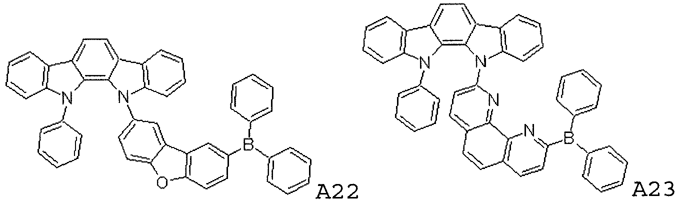

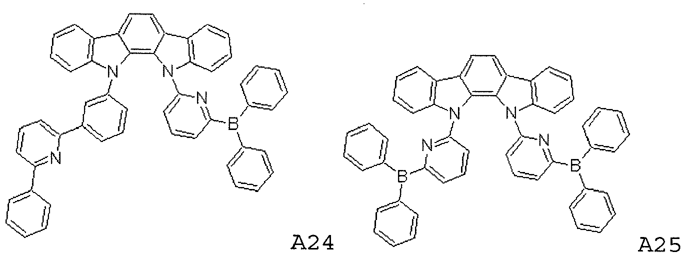

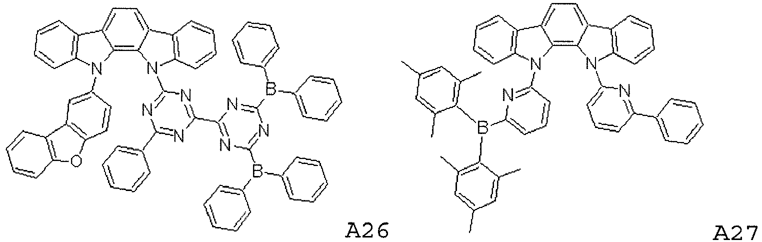

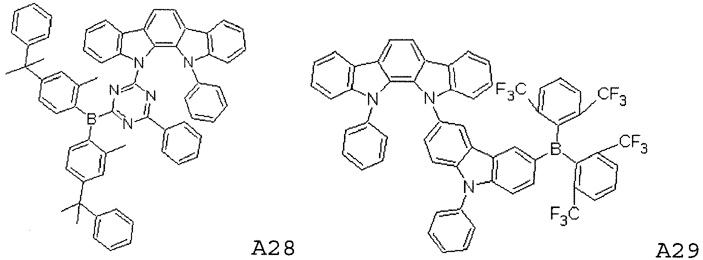

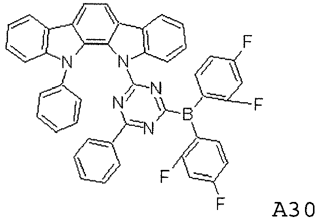

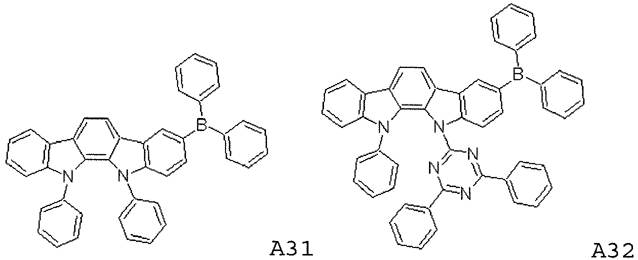

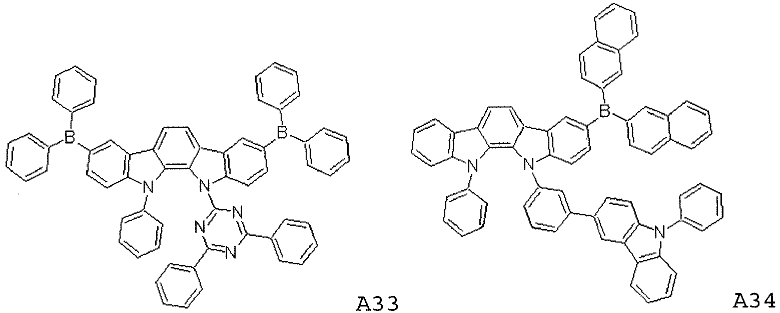

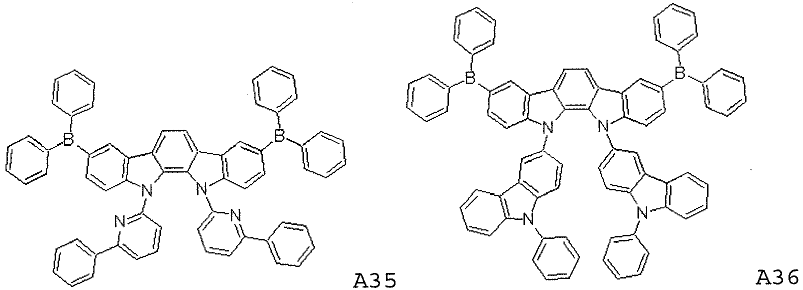

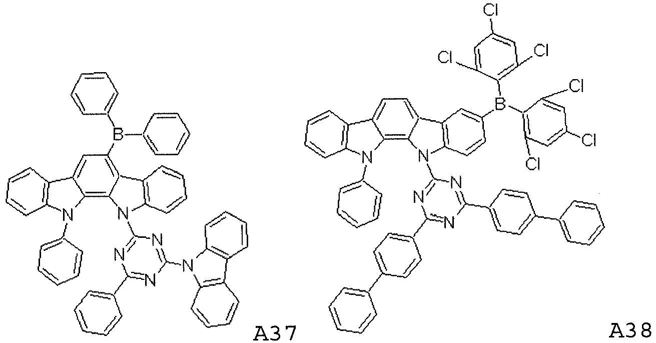

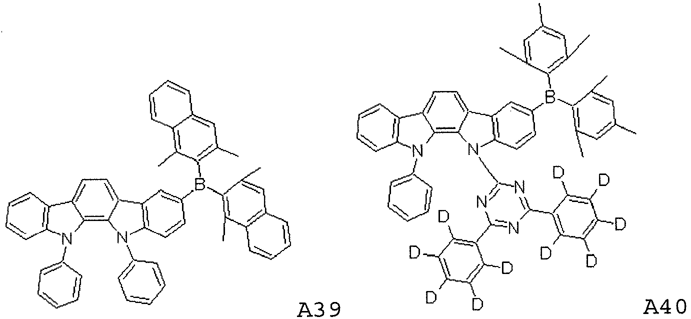

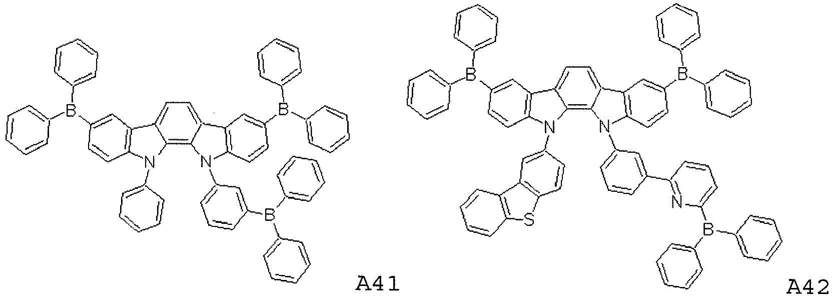

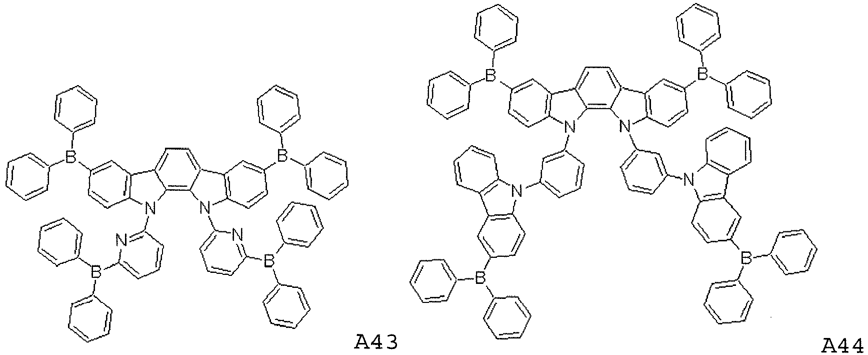

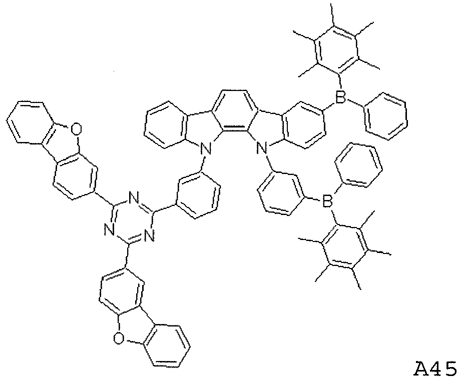

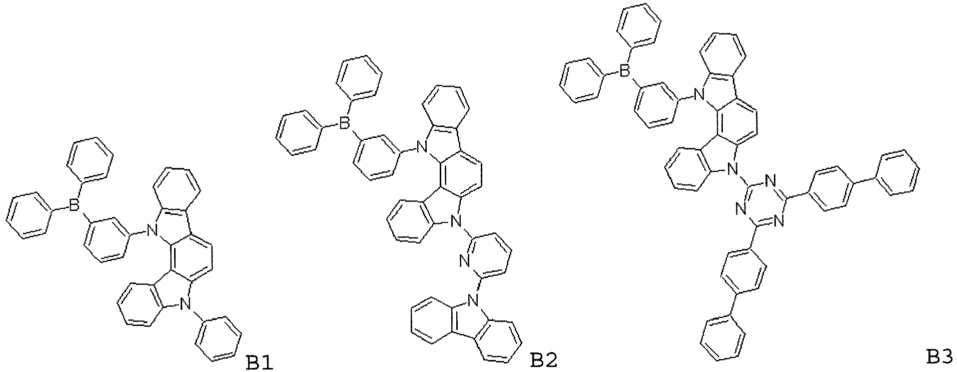

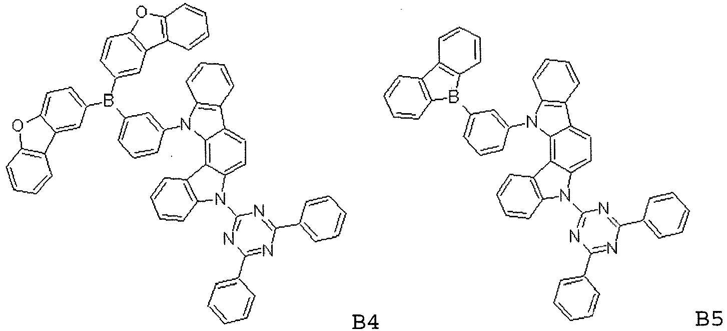

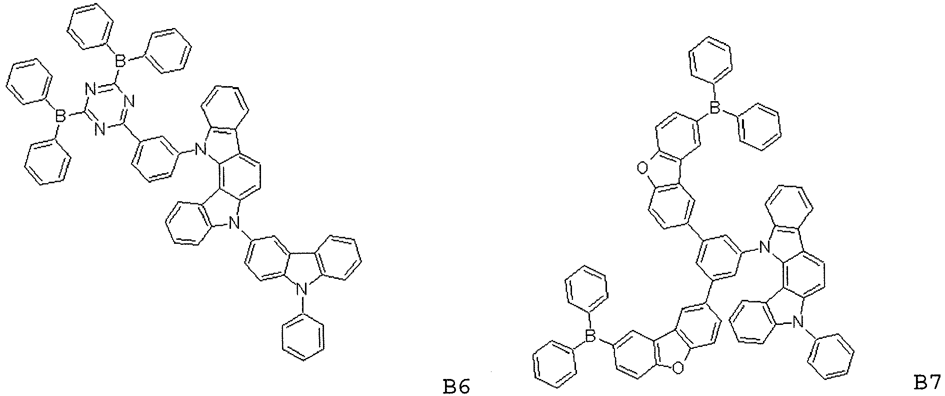

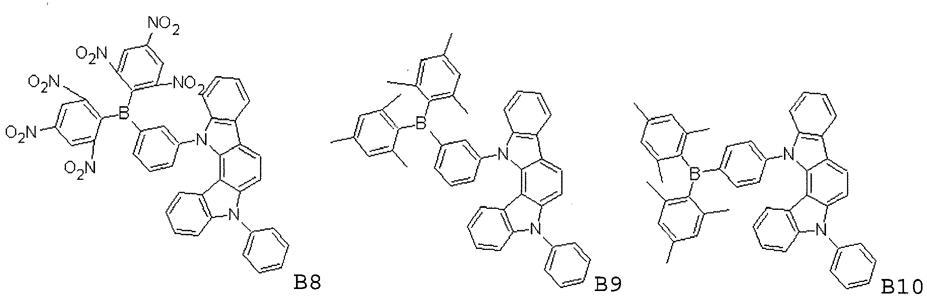

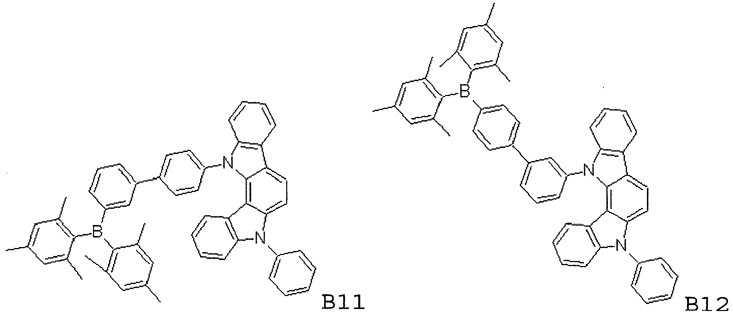

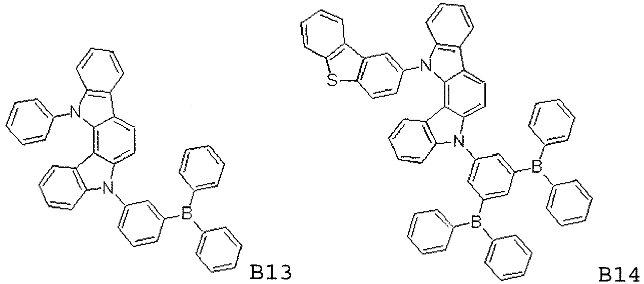

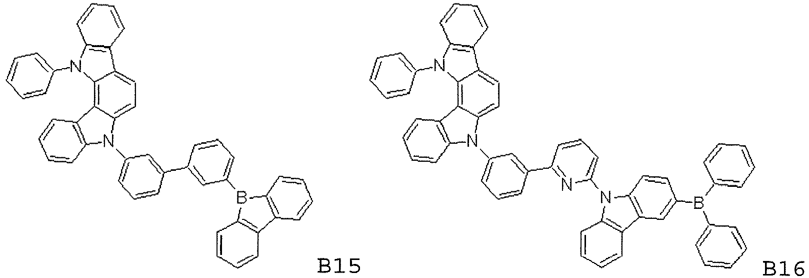

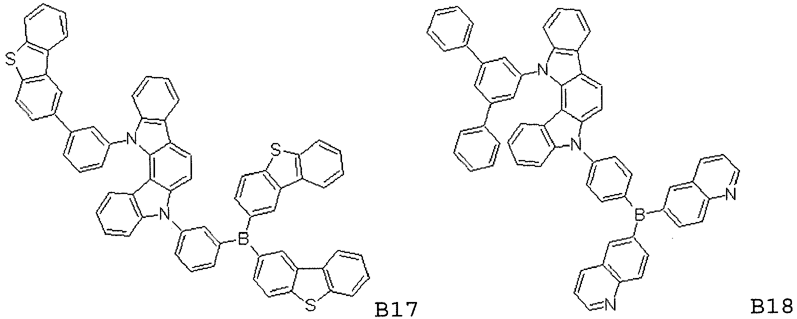

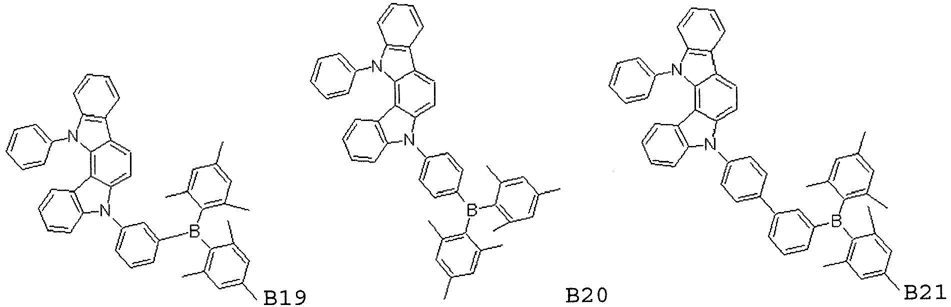

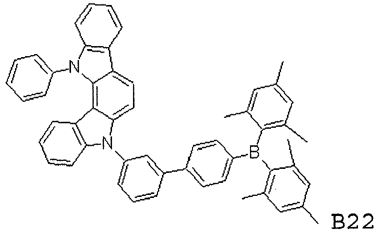

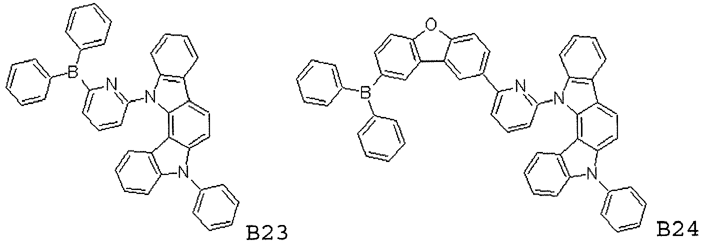

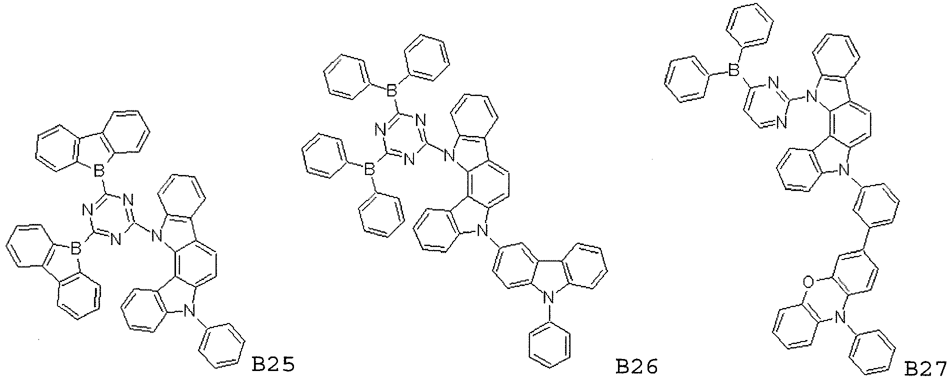

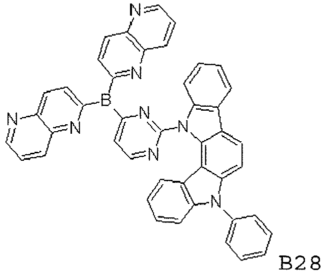

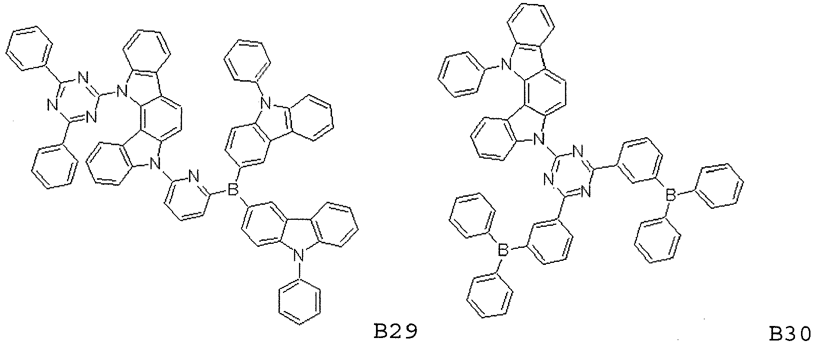

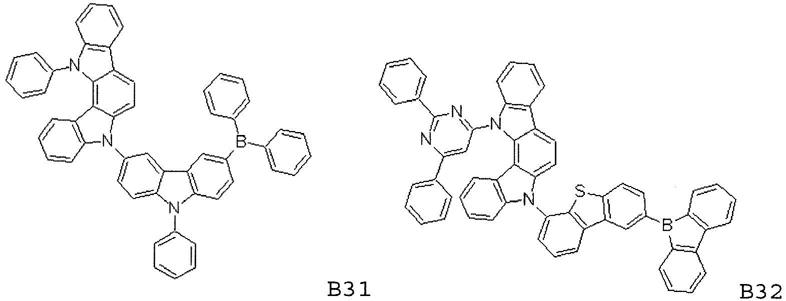

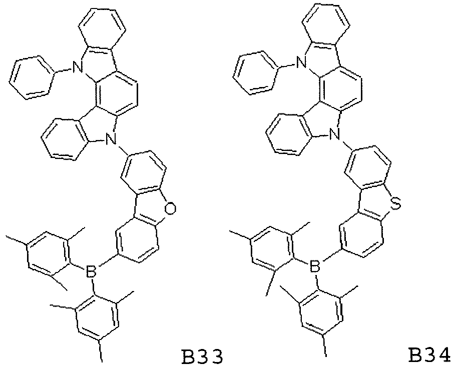

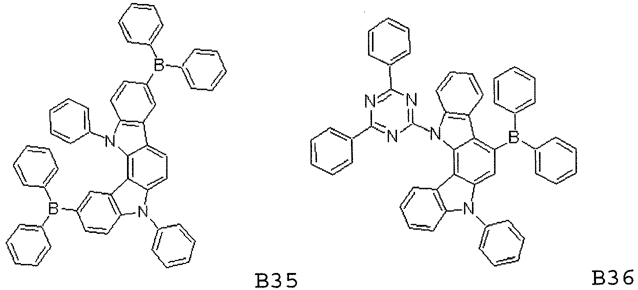

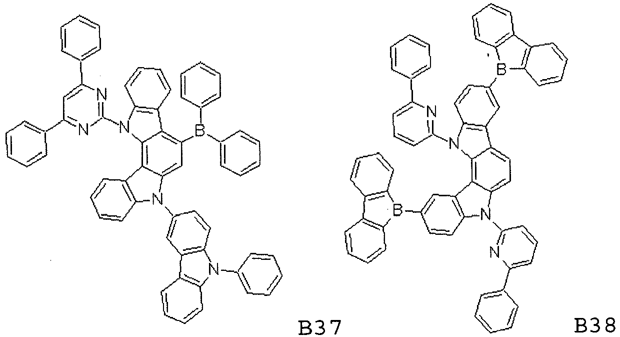

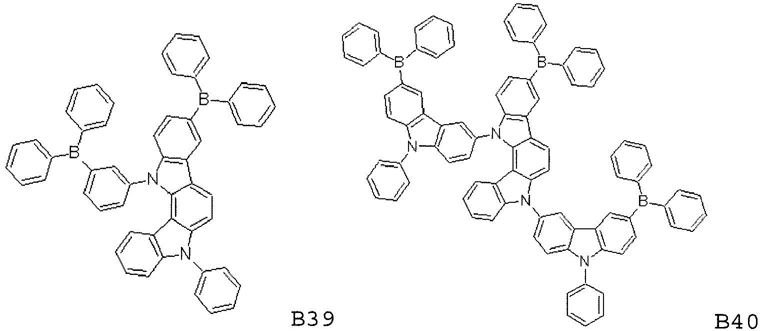

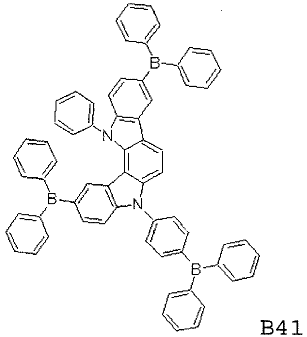

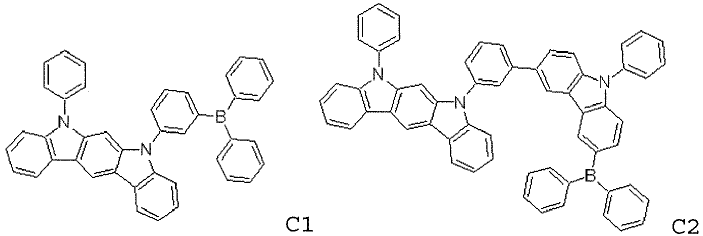

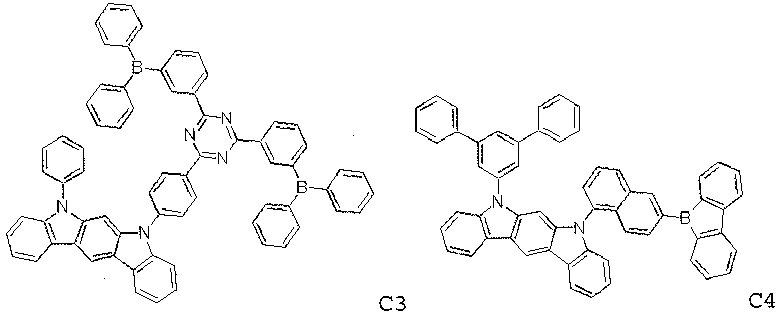

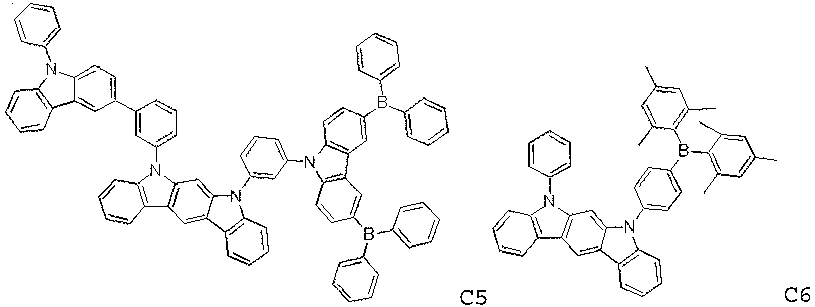

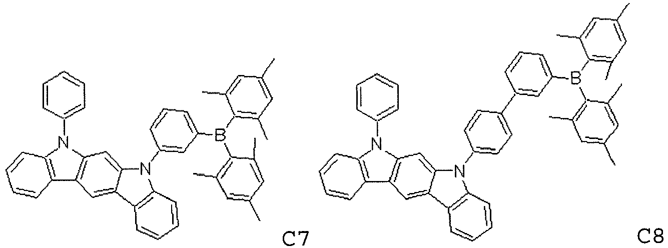

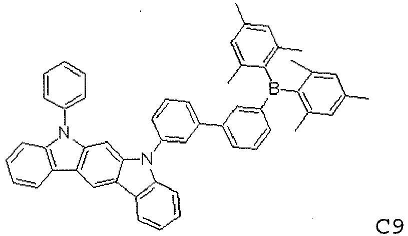

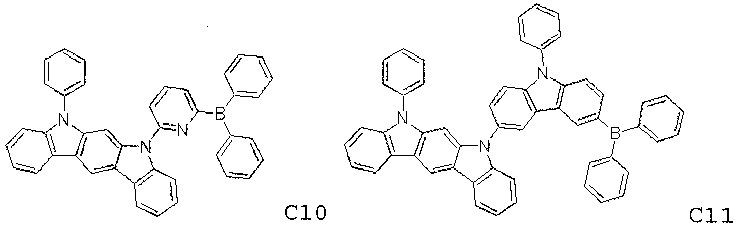

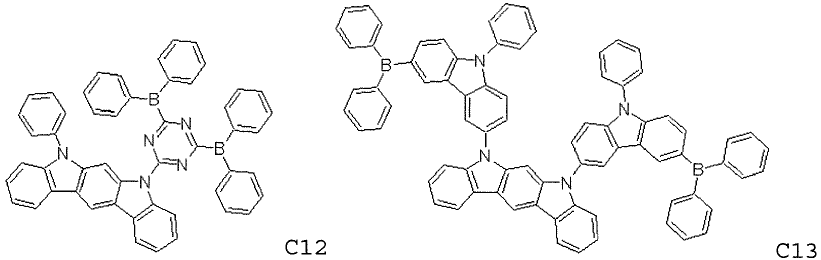

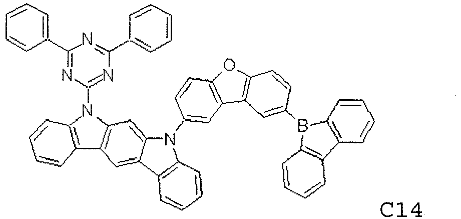

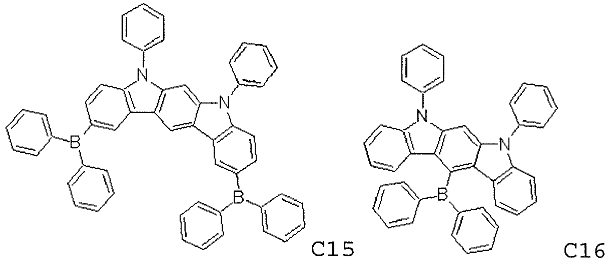

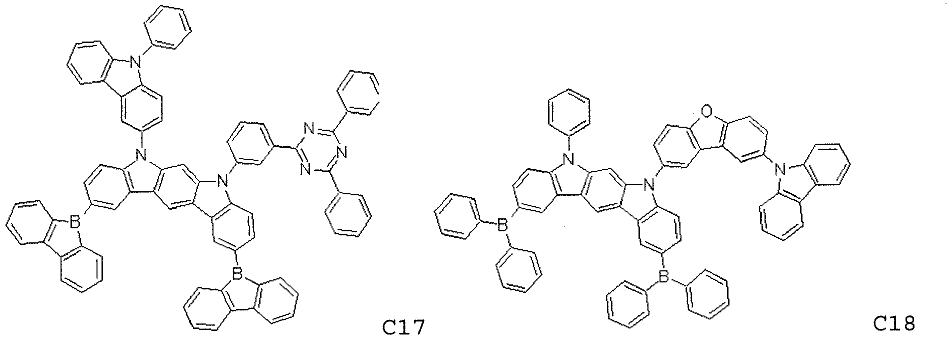

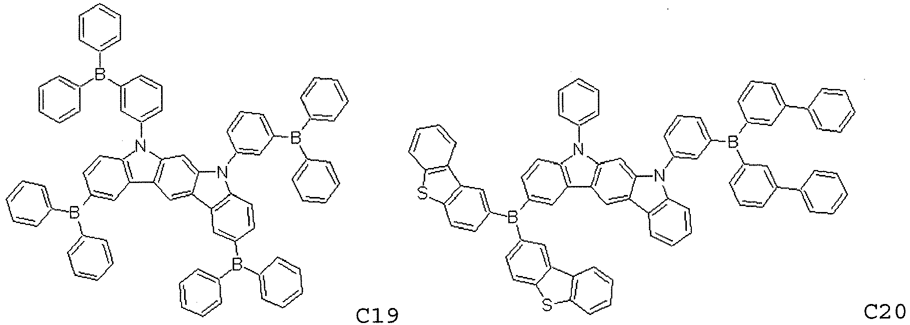

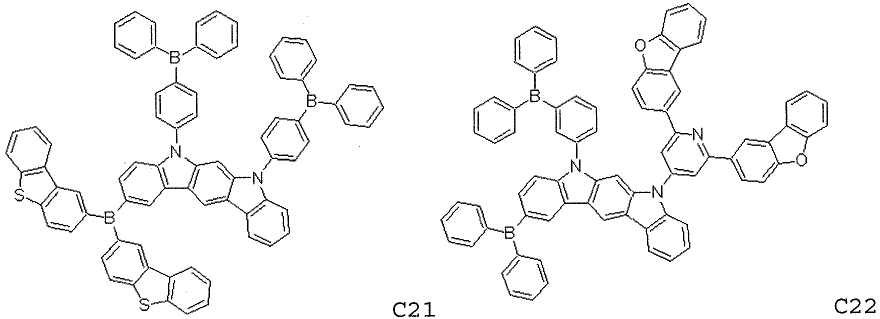

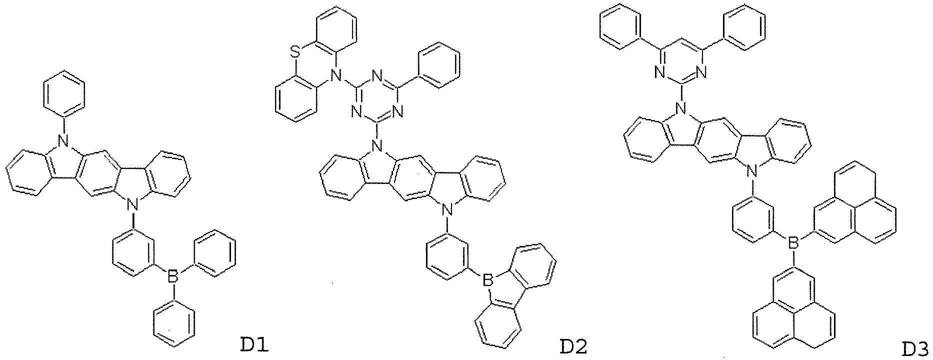

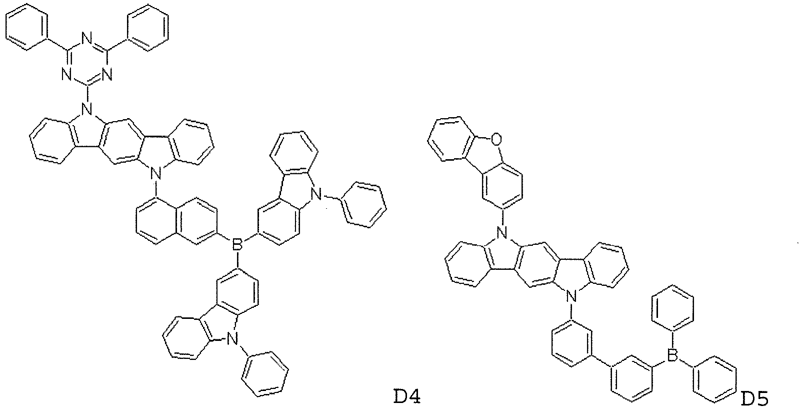

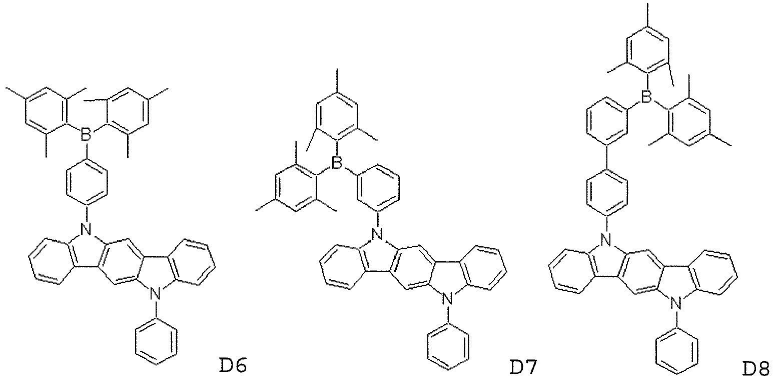

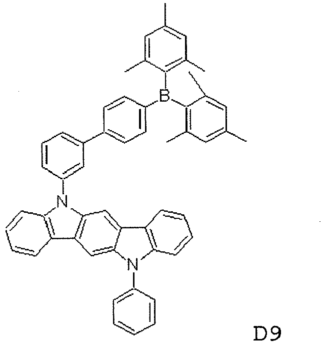

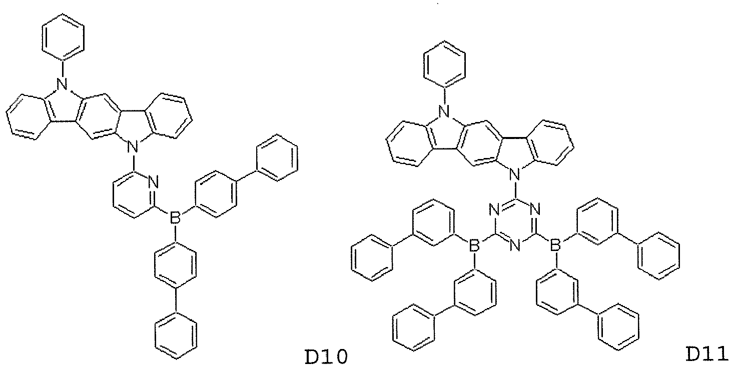

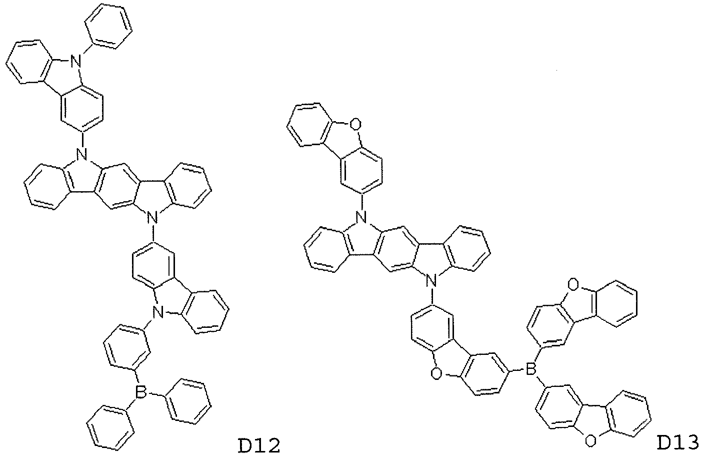

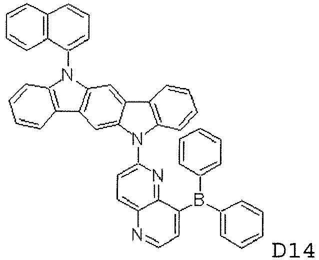

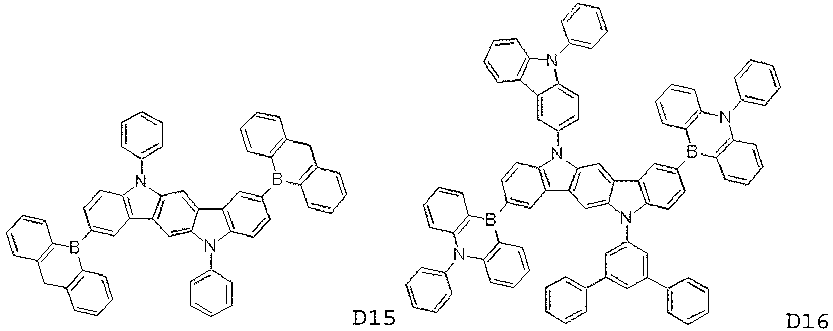

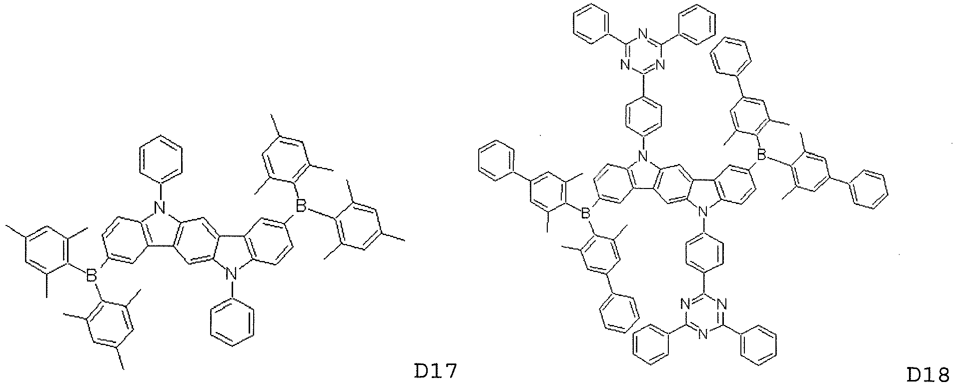

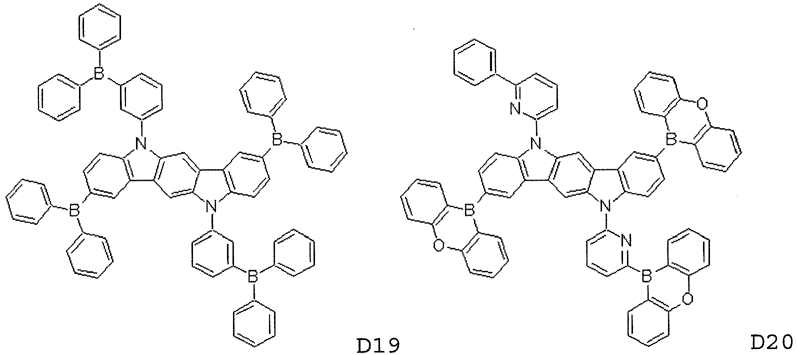

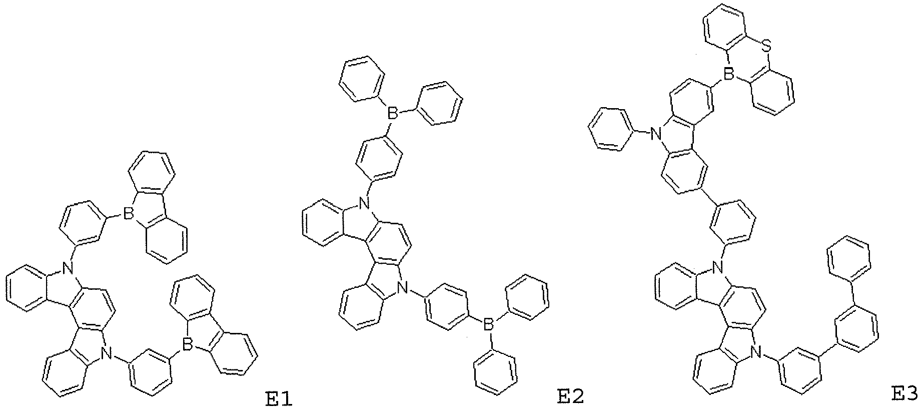

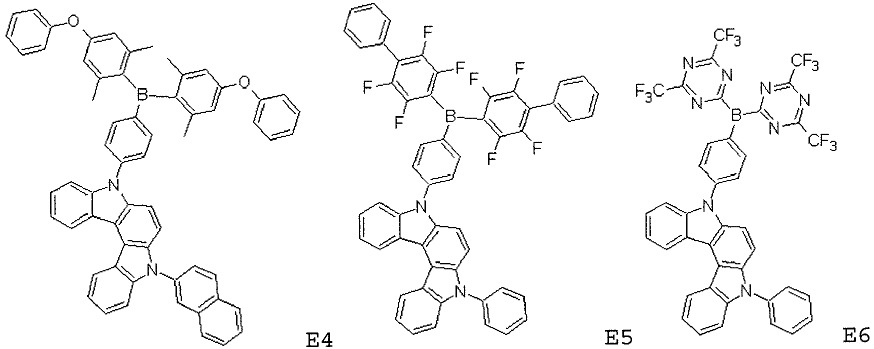

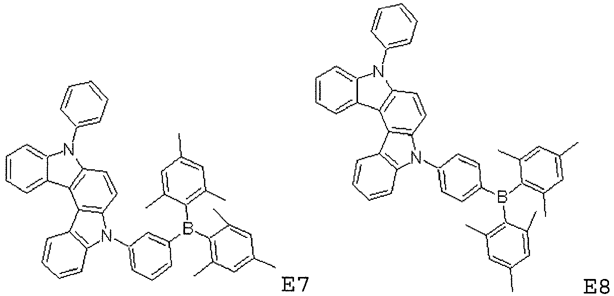

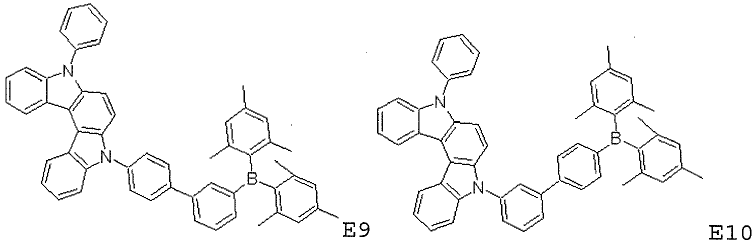

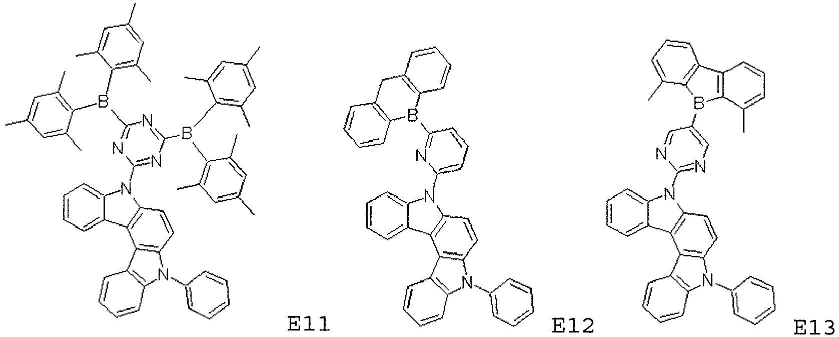

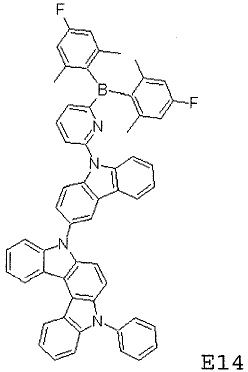

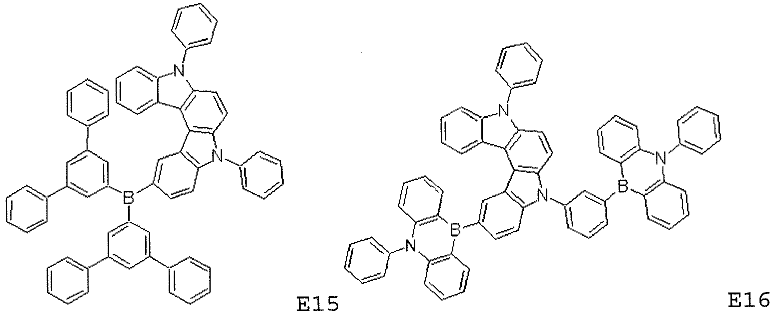

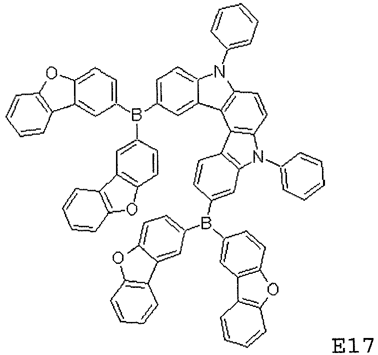

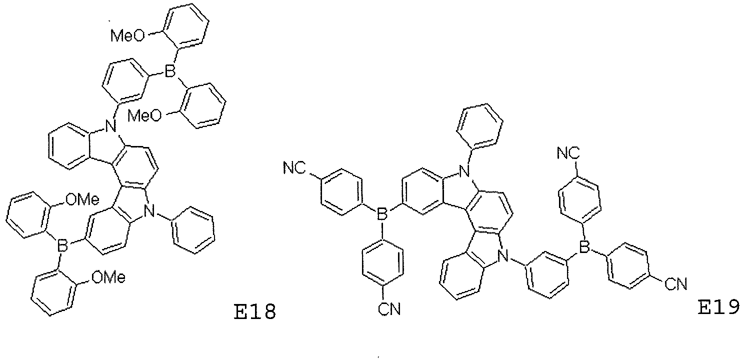

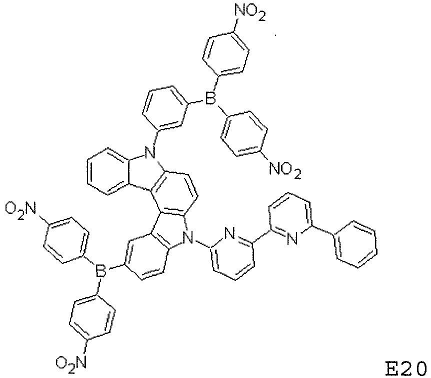

When the indolocarbazole compound represented by the general formula (1) (hereinafter sometimes referred to as compound of the present invention) is contained in at least one of a plurality of organic layers of an organic EL device formed by laminating an anode, the plurality of organic layers, and a cathode on a substrate, an excellent organic electroluminescent device is provided. A light-emitting layer, a hole-transporting layer, an electron-transporting layer, a hole-blocking layer, or an electron-blocking layer is suitable as the organic layer in which the indolocarbazole compound is contained. Here, when the compound of the present invention is used in the light-emitting layer, the compound can be used as a host material for the light-emitting layer containing a fluorescent light-emitting, delayed fluorescent light-emitting, or phosphorescent light-emitting dopant. In addition, the compound of the present invention can be used as an organic light-emitting material that radiates fluorescence and delayed fluorescence. The compound of the present invention is particularly preferably incorporated as a host material for the light-emitting layer containing the phosphorescent light-emitting dopant.

Next, an organic EL device of the present invention is described.

The organic EL device of the present invention includes organic layers including at least one light-emitting layer between an anode and a cathode laminated on a substrate. In addition, at least one of the organic layers contains the indolocarbazole compound. The compound for an organic EL device of the present invention is advantageously contained in the light-emitting layer together with a phosphorescent light-emitting dopant.

Next, the structure of the organic EL device of the present invention is described with reference to the drawings. However, the structure of the organic EL device of the present invention is by no means limited to one illustrated in the drawings.

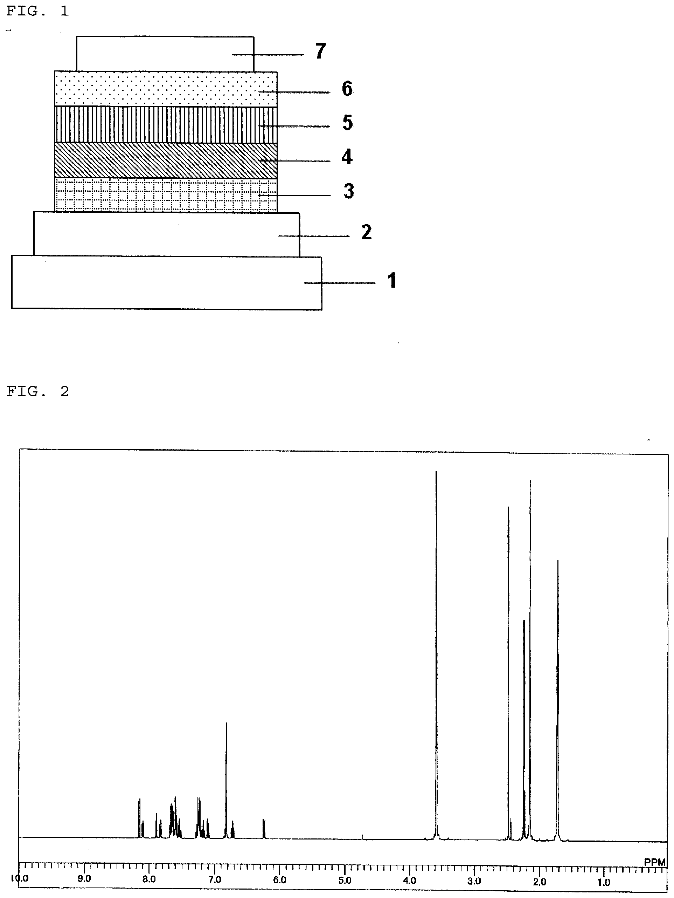

FIG. 1 is a sectional view illustrating a structure example of a general organic EL device used in the present invention. Reference numeral 1 represents a substrate, reference numeral 2 represents an anode, reference numeral 3 represents a hole-injecting layer, reference numeral 4 represents a hole-transporting layer, reference numeral 5 represents a light-emitting layer, reference numeral 6 represents an electron-transporting layer, and reference numeral 7 represents a cathode. The organic EL device of the present invention may include an exciton-blocking layer adjacent to the light-emitting layer, or may include an electron-blocking layer between the light-emitting layer and the hole-injecting layer. The exciton-blocking layer may be inserted on any of the anode side and the cathode side of the light-emitting layer, and may also be inserted simultaneously on both sides. The organic EL device of the present invention includes the substrate, the anode, the light-emitting layer, and the cathode as its essential layers . The organic EL device of the present invention preferably includes a hole-injecting/transporting layer and an electron-injecting/transporting layer in addition to the essential layers, and more preferably includes a hole-blocking layer between the light-emitting layer and the electron-injecting/transporting layer. It should be noted that the hole-injecting/transporting layer means any one or both of the hole-injecting layer and the hole-transporting layer, and that the electron-injecting/transporting layer means any one or both of an electron-injecting layer and the electron-transporting layer.

It should be noted that it is possible to adopt a reverse structure as compared to FIG. 1, that is, the reverse structure being formed by laminating the layers on the substrate 1 in the order of the cathode 7, the electron-transporting layer 6, the light-emitting layer 5, the hole-transporting layer 4, and the anode 2. In this case as well, some layers may be added or eliminated if necessary.

### -Substrate-

The organic EL device of the present invention is preferably supported by a substrate. The substrate is not particularly limited, and any substrate that has long been conventionally used for an organic EL device may be used. For example, a substrate made of glass, a transparent plastic, quartz, or the like may be used.

### -Anode-

Preferably used as the anode in the organic EL device is an anode formed by using, as an electrode substance, any of a metal, an alloy, an electrically conductive compound, and a mixture thereof, all of which have a large work function (4 eV or more). Specific examples of such electrode substance include metals such as Au and conductive transparent materials such as CuI, indium tin oxide (ITO), SnO₂, and ZnO. Further, it may be possible to use a material such as IDIXO (In₂O₃-ZnO), which may be used for manufacturing an amorphous, transparent conductive film. In order to produce the anode, it may be possible to form any of those electrode substances into a thin film by using a method such as vapor deposition or sputtering and form a pattern having a desired shape thereon by photolithography. Alternatively, in the case of not requiring high pattern accuracy (about 100 µm or more), a pattern may be formed via a mask having a desired shape when any of the above-mentioned electrode substances is subj ected to vapor deposition or sputtering. Alternatively, when a coatable substance such as an organic conductive compound is used, it is also possible to use a wet film-forming method such as a printing method or a coating method. When luminescence is taken out from the anode, the transmittance of the anode is desirably controlled to more than 10%. Further, the sheet resistance as the anode is preferably several hundred Ω/□ or less. Further, the thickness of the film is, depending on its material, selected from usually the range of from 10 to 1,000 nm, preferably the range of from 10 to 200 nm.

### -Cathode-

On the other hand, used as the cathode is a cathode formed by using, as an electrode substance, any of a metal (referred to as electron-injecting metal), an alloy, an electrically conductive compound, and a mixture thereof, all of which have a small work function (4 eV or less). Specific examples of such electrode substance include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Of those, for example, a mixture of an electron-injecting metal and a second metal as a stable metal having a larger work function value than the former metal, such as a magnesium/silver mixture, a magnesium/aluminum mixture, a magnesium/indium mixture, an aluminum/aluminum oxide (Al₂O₃) mixture, or a lithium/aluminum mixture, or aluminum is suitable from the viewpoints of electron-injecting property and durability against oxidation or the like. The cathode may be produced by forming any of those electrode substances into a thin film by using a method such as vapor deposition or sputtering. Further, the sheet resistance as the cathode is preferably several hundred Ω/□ or less, and the thickness of the film is selected from usually the range of from 10 nm to 5 µm, preferably the range of from 50 to 200 nm. It should be noted that, in order for luminescence produced to pass through, any one of the anode and cathode of the organic EL device is preferably transparent or semi-transparent, because the light emission luminance improves.

Further, after any of the above-mentioned metals is formed into a film having a thickness of from 1 to 20 nm as a cathode, any of the conductive transparent materials mentioned in the description of the anode is formed into a film on the cathode, thereby being able to produce a transparent or semi-transparent cathode. Then, by applying this, it is possible to produce a device in which both the anode and cathode have transparency.

### -Light-emitting Layer-

The light-emitting layer is a layer that emits light after the production of an exciton by the recombination of a hole injected from the anode and an electron injected from the cathode, and the light-emitting layer contains an organic light-emitting material and a host material.

When the light-emitting layer is a fluorescent light-emitting layer, a fluorescent light-emitting material can be used alone in the light-emitting layer. However, it is preferred that the fluorescent light-emitting material be used as a fluorescent light-emitting dopant and the host material be mixed.

The indolocarbazole compound represented by the general formula (1) can be used as the fluorescent light-emitting material in the light-emitting layer. However, the fluorescent light-emitting material is known through, for example, many patent literatures, and hence can be selected therefrom. Examples thereof include a benzoxazole derivative, a benzothiazole derivative, a benzimidazole derivative, a styrylbenzene derivative, a polyphenyl derivative, a diphenylbutadiene derivative, a tetraphenylbutadiene derivative, a naphthalimide derivative, a coumarine derivative, a fused aromatic compound, a perinone derivative, an oxadiazole derivative, an oxazine derivative, an aldazine derivative, a pyrrolidine derivative, a cyclopentadiene derivative, a bisstyrylanthracene derivative, a quinacridone derivative, a pyrrolopyridine derivative, a thiadiazolopyridine derivative, a styrylamine derivative, a diketopyrrolopyrrole derivative, an aromatic dimethylidene compound, various metal complexes typified by a metal complex of a 8-quinolinol derivative, and a metal complex, rare earth complex, or transition metal complex of a pyrromethene derivative, polymer compounds such as polythiophene, polyphenylene, and polyphenylene vinylene, and an organic silane derivative. Of those, for example, the following compound is preferred: a fused aromatic compound, a styryl compound, a diketopyrrolopyrrole compound, an oxazine compound, or a pyrromethene metal complex, transition metal complex, or lanthanoid complex. For example, the following compound is more preferred: naphthacene, pyrene, chrysene, triphenylene, benzo [c] phenanthrene, benzo [a] anthracene, pentacene, perylene, fluoranthene, acenaphthofluoranthene, dibenzo[a,j] anthracene, dibenzo[a,h] anthracene, benzo[a]naphthacene, hexacene, anthanthrene, naphtho[2,1-f]isoquinoline, α-naphthaphenanthridine, phenanthroxazole, quinolino[6,5-f]quinoline, or benzothiophanthrene. Those compounds may each have an alkyl group, aryl group, aromatic heterocyclic group, or diarylamino group as a substituent.

The indolocarbazole compound represented by the general formula (1) can be used as a fluorescent host material in the light-emitting layer. However, the fluorescent host material is known through, for example, many patent literatures, and hence can be selected therefrom. For example, the following material can be used: a compound having a fused aryl ring such as naphthalene, anthracene, phenanthrene, pyrene, chrysene, naphthacene, triphenylene, perylene, fluoranthene, fluorene, or indene, or a derivative thereof; an aromatic amine derivative such as N,N'-dinaphthyl-N,N'-diphenyl-4,4'-diphenyl-1,1'-diamine; a metal chelated oxinoid compound typified by tris(8-quinolinato)aluminum(III); a bisstyryl derivative such as a distyrylbenzene derivative; a tetraphenylbutadiene derivative; an indene derivative; a coumarin derivative; an oxadiazole derivative; a pyrrolopyridine derivative; a perinone derivative; a cyclopentadiene derivative; a pyrrolopyrrole derivative; a thiadiazolopyridine derivative; a dibenzofuran derivative; a carbazole derivative; an indolocarbazole derivative; a triazine derivative; or a polymer-based derivative such as a polyphenylene vinylene derivative, a poly-p-phenylene derivative, a polyfluorene derivative, a polyvinyl carbazole derivative, or a polythiophene derivative. However, the fluorescent host material is not particularly limited thereto.

When the fluorescent light-emitting material is used as a fluorescent light-emitting dopant and the host material is contained, the content of the fluorescent light-emitting dopant in the light-emitting layer desirably falls within the range of from 0.01 to 20 wt%, preferably from 0.1 to 10 wt%.

An organic EL device typically injects charges from both of its electrodes, i.e., its anode and cathode into a light-emitting substance to produce a light-emitting substance in an excited state, and causes the substance to emit light. In the case of a charge injection-type organic EL device, 25% of the produced excitons are said to be excited to a singlet excited state and the remaining 75% are said to be excited to a triplet excited state. As described in Advanced Materials 2009, 21, 4802-4806. , it has been known that after a specific fluorescent light-emitting substance has undergone an energy transition to a triplet excited state as a result of intersystem crossing or the like, the substance is subjected to inverse intersystem crossing to a singlet excited state by triplet-triplet annihilation or the absorption of a thermal energy to radiate fluorescence, thereby expressing thermally activated delayed fluorescence. The organic EL device of the present invention can also express delayed fluorescence. In this case, the light emission can include both fluorescent light emission and delayed fluorescent light emission, provided that light emission from the host material may be present in part of the light emission.

When the light-emitting layer is a delayed fluorescent light-emitting layer, a delayed fluorescent light-emitting material can be used alone in the light-emitting layer. However, it is preferred that the delayed fluorescent light-emitting material be used as a delayed fluorescent light-emitting dopant and the host material be mixed.

Although the indolocarbazole compound represented by the general formula (1) can be used as the delayed fluorescent light-emitting material in the light-emitting layer, a material selected from known delayed fluorescent light-emitting materials can also be used. Examples thereof include a tin complex, an indolocarbazole derivative, a copper complex, and a carbazole derivative. Specific examples thereof include, but not limited to, compounds described in the following non patent literatures and patent literature.

Adv. Mater. 2009, 21, 4802-4806, Appl. Phys. Lett. 98, 083302 (2011), JP 2011-213643 A, and J. Am. Chem. Soc. 2012, 134, 14706-14709.

Specific examples of the delayed fluorescent light-emitting material are shownbelow, but the delayed fluorescent light-emitting material is not limited to the following compounds.

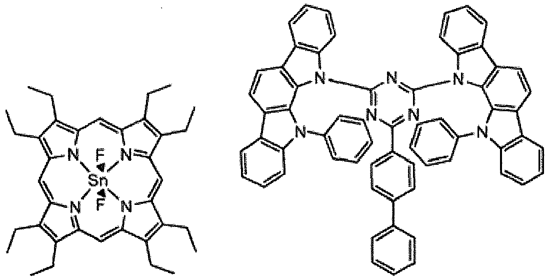

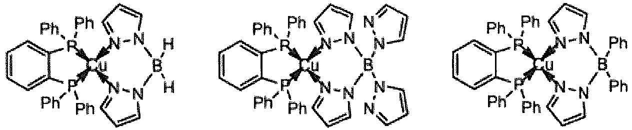

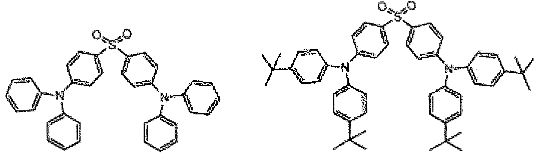

When the delayed fluorescent light-emitting material is used as a delayed fluorescent light-emitting dopant and the host material is contained, the content of the delayed fluorescent light-emitting dopant in the light-emitting layer desirably falls within the range of from 0.01 to 50 wt%, preferably from 0.1 to 20 wt%, more preferably from 0.01 to 10%.

The indolocarbazole compound represented by the general formula (1) can be used as the delayed fluorescent host material in the light-emitting layer. However, the delayed fluorescent host material may be selected from compounds other than the indolocarbazole. For example, the following compound can be used: a compound having a fused aryl ring such as naphthalene, anthracene, phenanthrene, pyrene, chrysene, naphthacene, triphenylene, perylene, fluoranthene, fluorene, or indene, or a derivative thereof; an aromatic amine derivative such as N,N'-dinaphthyl-N,N'-diphenyl-4,4'-diphenyl-1,1'-diamine; a metal chelated oxinoid compound typified by tris(8-quinolinato)aluminum(III); a bisstyryl derivative such as a distyrylbenzene derivative; a tetraphenylbutadiene derivative; an indene derivative; a coumarin derivative; an oxadiazole derivative; a pyrrolopyridine derivative; a perinone derivative; a cyclopentadiene derivative; a pyrrolopyrrole derivative; a thiadiazolopyridine derivative; a dibenzofuran derivative; a carbazole derivative; an indolocarbazole derivative; a triazine derivative; or a polymer-based derivative such as a polyphenylene vinylene derivative, a poly-p-phenylene derivative, a polyfluorene derivative, a polyvinyl carbazole derivative, a polythiophene derivative, or an arylsilane derivative. However, the delayed fluorescent host material is not particularly limited thereto.

When the light-emitting layer is a phosphorescent light-emitting layer, the light-emitting layer contains a phosphorescent light-emitting dopant and a host material. It is recommended to use, as a material for the phosphorescent light-emitting dopant, a material containing an organic metal complex including at least one metal selected from ruthenium, rhodium, palladium, silver, rhenium, osmium, iridium, platinum, and gold. Specific examples thereof include, but not limited to, the compounds disclosed in the following patent publications.

For example, WO 2009/073245 A1, WO 2009/046266 A1, WO 2007/095118 A3, WO 2008/156879 A1, WO 2008/140657 A1, US 2008/261076 A1, JP 2008-542203 A, WO 2008/054584 A1, JP 2008-505925 A, JP 2007-522126 A, JP 2004-506305 A, JP 2006-513278 A, JP 2006-50596 A, WO 2006/046980 A1, WO 2005/113704 A3, US 2005/260449 A1, US 2005/2260448 A1, US 2005/214576 A1, WO 2005/076380 A3, US 2005/119485 A1, WO 2004/045001 A3, WO 2004/045000 A3, WO 2006/100888 A1, WO 2007/004380 A1, WO 2007/023659 A1, WO 2008/035664 A1, JP 2003-272861 A, JP 2004-111193 A, JP 2004-319438 A, JP 2007-2080 A, JP 2007-9009 A, JP 2007-227948 A, JP 2008-91906 A, JP 2008-311607 A, JP 2009-19121 A, JP2009-46601A, JP2009-114369A, JP2003-253128 A, JP2003-253129 A, JP 2003-253145 A, JP 2005-38847 A, JP 2005-82598 A, JP 2005-139185 A, JP2005-187473 A, JP2005-220136 A, JP 2006-63080 A, JP 2006-104201 A, JP2006-111623 A, JP2006-213720 A, JP2006-290891 A, JP2006-298899 A, JP 2006-298900 A, WO 2007/018067 A1, WO 2007/058080 A1, WO 2007/058104 A1, JP 2006-131561 A, JP 2008-239565 A, JP 2008-266163 A, JP 2009-57367 A, JP 2002-117978 A, JP 2003-123982 A, JP 2003-133074 A, JP 2006-93542 A, JP 2006-131524 A, JP 2006-261623 A, JP 2006-303383 A, JP 2006-303394 A, JP 2006-310479 A, JP 2007-88105 A, JP 2007-258550 A, JP 2007-324309 A, JP 2008-270737 A, JP 2009-96800 A, JP 2009-161524 A, WO 2008/050733 A1, JP 2003-73387 A, JP 2004-59433 A, JP 2004-155709 A, JP 2006-104132 A, JP 2008-37848 A, JP 2008-133212 A, JP 2009-57304 A, JP2009-286716 A, JP 2010-83852 A, JP 2009-532546 A, JP 2009-536681 A, and JP 2009-542026 A.

Preferred examples of the phosphorescent light-emitting dopant include complexes such as Ir(ppy)3, complexes such as Ir(bt)2·acac3, and complexes such as PtOEt3, the complexes each having a noble metal element such as Ir as a central metal. Specific examples of those complexes are shown below, but the complexes are not limited to the compounds described below.

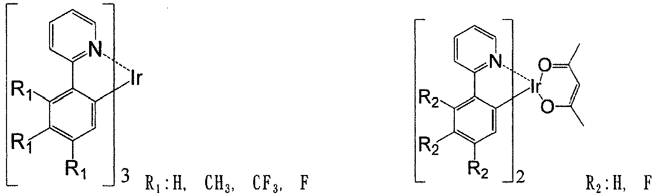

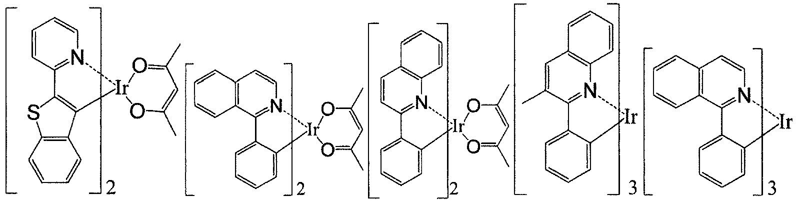

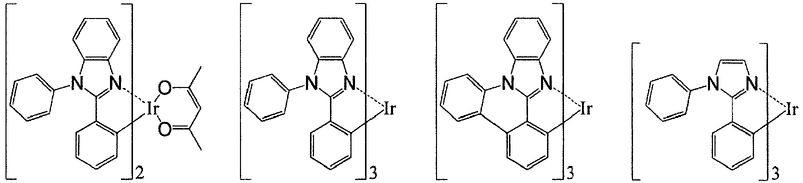

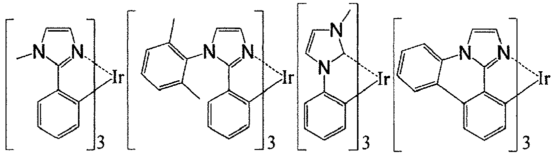

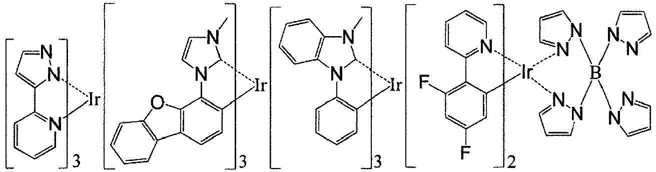

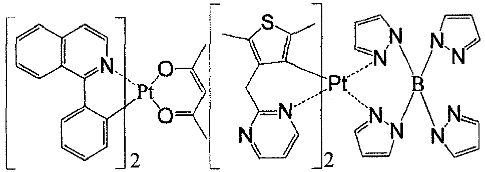

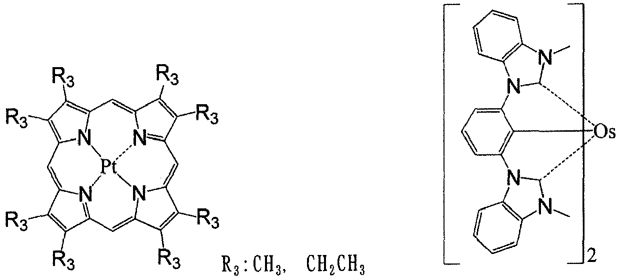

It is desirable that the content of the phosphorescent light-emitting dopant in the light-emitting layer be in the range of from 2 to 40 wt%, preferably from 5 to 30 wt%.

When the light-emitting layer is a phosphorescent light-emitting layer, it is preferred to use, as a host material in the light-emitting layer, the indolocarbazole compound represented by the general formula (1). However, when the indolocarbazole compound is used in any of the organic layers other than the light-emitting layer, the material to be used in the light-emitting layer may be another host material other than the indolocarbazole compound, or the indolocarbazole compound and any other host material may be used in combination. Further, a plurality of kinds of known host materials may be used in combination.

It is preferred to use, as a usable known host compound, a compound that has a hole-transporting ability or an electron-transporting ability, is capable of preventing luminescence from having a longer wavelength, and has a high glass transition temperature.

Such other host materials are known because they are mentioned in many patent literatures and the like, and hence a suitable host material may be chosen from those in the patent literatures and the like. Specific examples of the host material include, but are not particularly limited to, an indole derivative, a carbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidene-based compound, a porphyrin-based compound, an anthraquinodimethane derivative, an anthrone derivative, a diphenylquinone derivative, a thiopyran dioxide derivative, a heterocyclic tetracarboxylic acid anhydride such as naphthalene perylene, a phthalocyanine derivative, various metal complexes typified by a metal complex of an 8-quinolinol derivative, a metal phthalocyanine, and metal complexes of benzoxazole and benzothiazole derivatives, and polymer compounds such as a polysilane-based compound, a poly(N-vinylcarbazole) derivative, an aniline-based copolymer, a thiophene oligomer, a polythiophene derivative, a polyphenylene derivative, a polyphenylenevinylene derivative, and a polyfluorene derivative.

The light-emitting layer, which may be any one of a fluorescent light-emitting layer, a delayed fluorescent light-emitting layer, and a phosphorescent light-emitting layer, is preferably the phosphorescent light-emitting layer.

### -Injecting Layer-

The injecting layer refers to a layer formed between an electrode and an organic layer for the purpose of lowering a driving voltage and improving light emission luminance, and includes a hole-injecting layer and an electron-injecting layer. The injecting layer may be interposed between the anode and the light-emitting layer or the hole-transporting layer, or may be interposed between the cathode and the light-emitting layer or the electron-transporting layer. The injecting layer may be formed as required.

### -Hole-blocking Layer-

The hole-blocking layer has, in a broad sense, the function of an electron-transporting layer, and is formed of a hole-blocking material that has a remarkably small ability to transport holes while having a function of transporting electrons, and hence the hole-blocking layer is capable of improving the probability of recombining an electron and a hole by blocking holes while transporting electrons.

It is preferred to use the indolocarbazole compound represented by the general formula (1) for the hole-blocking layer. However, when the indolocarbazole compound is used in any other organic layer, a known material for a hole-blocking layer may be used. Further, it is possible to use, as a material for the hole-blocking layer, any of the below-mentioned materials for the electron-transporting layer as required.

### -Electron-blocking Layer-

The electron-blocking layer is formed of a material that has a remarkably small ability to transport electrons while having a function of transporting holes, and hence the electron-blocking layer is capable of improving the probability of recombining an electron and a hole by blocking electrons while transporting holes.

Although the indolocarbazole compound represented by the general formula (1) according to the present invention can be used as a material for the electron-blocking layer, another material, i.e., any of the below-mentioned materials for the hole-transporting layer can be used as required. The thickness of the electron-blocking layer is preferably from 3 to 100 nm, more preferably from 5 to 30 nm.

### -Exciton-blocking Layer-

The exciton-blocking layer refers to a layer for blocking excitons produced by the recombination of a hole and an electron in the light-emitting layer from diffusing into charge-transporting layers. Inserting this layer enables effective confinement of the excitons in the light-emitting layer, thereby being able to improve the luminous efficiency of the device. The exciton-blocking layer may be inserted on any of the anode side and the cathode side of the adjacent light-emitting layer, and may also be inserted simultaneously on both sides.

Although the indolocarbazole compound represented by the general formula (1) can be used as a material for the exciton-blocking layer, as other materials therefor, there are given, for example, 1,3-dicarbazolylbenzene (mCP) and bis(2-methyl-8-quinolinolato)-4-phenylphenolatoaluminum(III)

### (BAlq) .

### -Hole-transporting Layer-

The hole-transporting layer is formed of a hole-transporting material having a function of transporting holes, and a single hole-transporting layer or a plurality of hole-transporting layers may be formed.

The hole-transporting material has hole-injecting property or hole-transporting property or has electron-blocking property, and any of an organic material and an inorganic material may be used as the hole-transporting material. Although it is preferred to use the indolocarbazole compound represented by the general formula (1) for the hole-transporting layer, any compound selected from conventionally known compounds may be used. Examples of the known hole-transporting material that may be used include a triazole derivative, an oxadiazole derivative, an imidazole derivative, a polyarylalkane derivative, a pyrazoline derivative, and a pyrazolone derivative, a phenylenediamine derivative, an arylamine derivative, an amino-substituted chalcone derivative, an oxazole derivative, a styrylanthracene derivative, a fluorenone derivative, a hydrazone derivative, a stilbene derivative, a silazane derivative, an aniline-based copolymer, and a conductive high-molecular weight oligomer, inparticular, a thiophene oligomer. However, a porphyrin compound, an aromatic tertiary amine compound, or a styrylamine compound is preferably used, and an aromatic tertiary amine compound is more preferably used.

### -Electron-transporting Layer-

The electron-transporting layer is formed of a material having a function of transporting electrons, and a single electron-transporting layer or a plurality of electron-transporting layers may be formed.

An electron-transporting material (which also serves as a hole-blocking material in some cases) only needs to have a function of transferring electrons injected from the cathode into the light-emitting layer. Although it is preferred to use the material represented by the general formula (1) according to the present invention for the electron-transporting layer, any compound selected from conventionally known compounds may be used. Examples thereof include a nitro-substituted fluorene derivative, a diphenylquinone derivative, a thiopyran dioxide derivative, a carbodiimide, a fluorenylidenemethane derivative, anthraquinodimethane, an anthrone derivative, and an oxadiazole derivative. Further, it is also possible to use, as the electron-transporting material, a thiadiazole derivative prepared by substituting an oxygen atom on an oxadiazole ring with a sulfur atom in the oxadiazole derivative and a quinoxaline derivative that has a quinoxaline ring known as an electron withdrawing group. Further, it is also possible to use a polymer material in which any of those materials is introduced in a polymer chain or is used as a polymer main chain.

### Examples

Hereinafter, the present invention is described in more detail by way of Examples . It should be appreciated that the present invention is not limited to Examples below and may be carried out in various forms as long as the various forms do not deviate from the gist of the present invention.

The route described below was used to synthesize an indolocarbazole compound to be used as a material for a phosphorescent light-emitting device. It should be noted that the number of each compound corresponds to the number given to the exemplified compound.

### Synthesis Example 1

Synthesis of Compound B9

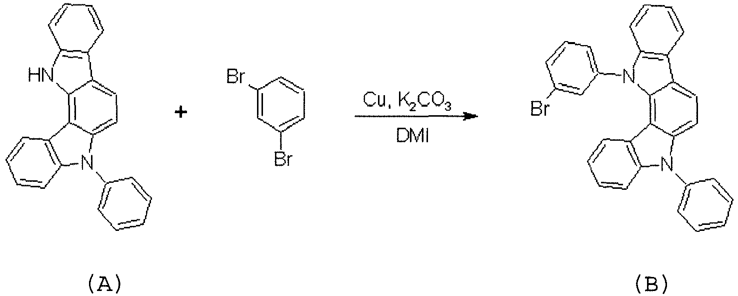

Under a nitrogen atmosphere, 5.00 g (0.0150 mol) of a compound (A), 25.0 g (0.106 mol) of dibromobenzene, 6.10 g (0.0960 mol) of copper, 22.8 g (0.165 mol) of potassium carbonate, and 30 ml of 1,3-dimethyl-2-imidazolidinone (DMI) were added and stirred at 190°C for 6 hr. The reaction solution was cooled to room temperature and poured into 800 ml of water, and the mixture was stirred at room temperature for 12 hr. A precipitated solid was separated by filtration and dissolved in 200 ml of tetrahydrofuran (THF), and 200 ml of 2 M HCl were added to the solution. After that, the mixture was extracted with 100 ml of ethyl acetate three times. An organic layer was dried with anhydrous magnesium sulfate, and then magnesium sulfate was separated by filtration and the solvent was removed. The resultant residue was purified by silica gel column chromatography to provide 6.18 g (0.0126 mol, 84% yield) of an intermediate (B) as a white solid.

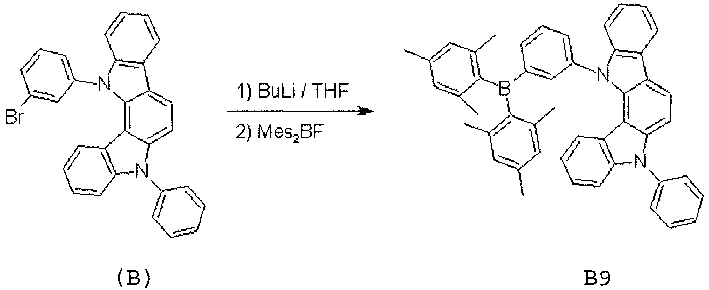

Under a nitrogen atmosphere, 6.00 g (0.0123 mol) of the intermediate (B) and 100 ml of THF were added and cooled to -78°C. 7.7 ml (0.0123 mol) of 1.59 M n-BuLi were added to the mixture, and the whole was stirred at -78°C for 30 min. After that, 4.96 g (0.0185 mol) of dimesitylfluoroborane were added to the resultant and the mixture was stirred at room temperature for 2 hr. After that, the solvent was removed, and the resultant residue was purified by silica gel column chromatography and recrystallization to provide 1.90 g (0.00289 mol, 23% yield) of Compound B9 as a pale yellow solid.

The APCI-TOFMS of the compound showed an [M+1] peak at an m/z of 657. FIG. 2 shows the results of its 1H-NMR measurement (measurement solvent: THF-d8).

### Example 1

Each thin film was laminated by a vacuum deposition method at a degree of vacuum of 4.0×10⁻⁵ Pa on a glass substrate on which an anode formed of ITO having a thickness of 110 nm had been formed. First, copper phthalocyanine (CuPC) was formed into a layer having a thickness of 25 nm on the ITO. Next, 4,4'-bis[N-(1-naphthyl)-N-phenylamino]biphenyl (NPB) was formed into a layer having a thickness of 40 nm to serve as a hole-transporting layer. Next, Compound (B9) as a host material and tris(2-phenylpyridine)iridium(III) (Ir(ppy)₃) as a phosphorescent light-emitting dopant were co-deposited from different deposition sources onto the hole-transporting layer to form a light-emitting layer having a thickness of 40 nm. The concentration of Ir(ppy)₃ in the light-emitting layer was 10.0 wt%. Next, tris(8-hydroxyquinolinato)aluminum(III) (Alq3) was formed into a layer having a thickness of 20 nm to serve as an electron-transporting layer. Further, lithium fluoride (LiF) was formed into a layer having a thickness of 1.0 nm to serve as an electron-injecting layer on the electron-transporting layer. Finally, aluminum (Al) was formed into a layer having a thickness of 70 nm to serve as an electrode on the electron-injecting layer. Thus, an organic EL device was produced.

An external power source was connected to the resultant organic EL device to apply a DC voltage to the device. As a result, it was confirmed that the device had such light-emitting characteristics as shown in Table 1. The columns "luminance", "voltage", and "luminous efficiency" in Table 1 show values at 20 mA/cm². It was found that the local maximum wavelength of the emission spectrum of the device was 520 nm and hence light emission from Ir(ppy)₃ was obtained.

### Examples 2 to 12

Compounds A1, A27, A33, A41, B4, B22, B33, C9, D8, D17, and E11 were synthesized in the same manner as in Synthesis Example 1.

Organic EL devices were each produced in the same manner as in Example 1 except that Compounds A1, A27, A33, A41, B4, B22, B33, C9, D8, D17, and E11 were each used instead of Compound B9 as the host material for the light-emitting layer of Example 1. It was found that the local maximum wavelength of the emission spectrum of each of the devices was 520 nm, and hence light emission from Ir(ppy)₃ was obtained. Table 1 shows the respective light-emitting characteristics.

### Comparative Example 1

An organic EL device was produced in the same manner as in Example 1 except that CBP was used as the host material for the light-emitting layer.

### Comparative Example 2

An organic EL device was produced in the same manner as in Example 1 except that the following compound Ho-1 was used as the host material for the light-emitting layer.

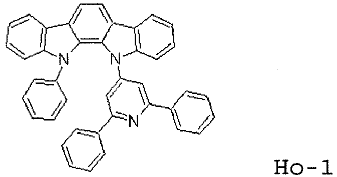

### Comparative Example 3

An organic EL device was produced in the same manner as in Example 1 except that the follwing compound Ho-2 was used as the host material for the light-emitting layer.

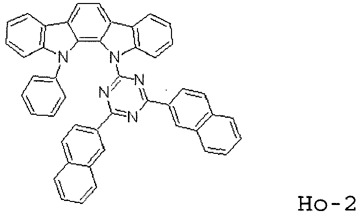

It was found that the local maximum wavelength of the emission spectrum of each of the organic EL devices produced in Comparative Examples 1 to 3 was 520 nm, and hence light emission from Ir(ppy)₃ was obtained. Table 1 shows the compounds each used as the host material and the respective light-emitting characteristics (at 20 mA/cm²).

**[Table 1]**

| | Compound | Luminance (cd/m²) | Voltage (V) | Visual luminous efficiency (lm/W) |
|---|---|---|---|---|
| Example 1 | B9 | 5,020 | 5.4 | 14.6 |
| 2 | A1 | 5,155 | 6.0 | 13.5 |
| 3 | A27 | 4,990 | 5.6 | 14.0 |
| 4 | A33 | 4,925 | 6.0 | 12.9 |
| 5 | A41 | 5,050 | 6.1 | 13.0 |
| 6 | B4 | 5,000 | 6.0 | 13.1 |
| 7 | B22 | 5,295 | 6.3 | 13.2 |
| 8 | B33 | 5,090 | 6.2 | 12.9 |
| 9 | C9 | 5,005 | 5.5 | 14.3 |
| 10 | D8 | 5,135 | 5.6 | 14.4 |
| 11 | D17 | 4,985 | 5.4 | 14.5 |
| 12 | E11 | 5,280 | 6.1 | 13.6 |
| Comparative Example 1 | CBP | 4,860 | 9.3 | 8.2 |
| 2 | Ho-1 | 4,713 | 7.4 | 10.0 |
| 3 | HO-2 | 3,980 | 6.1 | 10.2 |

It is found from Table 1 that the organic EL device using the indolocarbazole compound represented by the general formula (1) has a low driving voltage and shows good light-emitting characteristics as compared to those in the case where CBP generally known as a phosphorescent host is used. It is also found that the device shows good light-emitting characteristics as compared to those in the case where any one of Ho-1 and Ho-2 as compounds each having no boron-containing group on a linking group bonded to N of indolocarbazole or on benzene of indolocarbazole is used. The superiority of the organic EL device using the indolocarbazole compound is apparent from the foregoing.

### Industrial Applicability

The organic EL device according to the present invention has light-emitting characteristics, driving voltage, and durability at practically satisfactory levels. Thus, the organic EL device has a large technical value in applications to flat panel displays (display devices for mobile phones, in-vehicle display devices, display devices for OA computers, televisions, and the like), light sources utilizing characteristics of planar light emitters (light sources in lighting equipment and copying machines and backlight sources in liquid crystal displays and instruments), sign boards, sign lamps, and the like.

## Claims

1. A compound for an organic electroluminescent device, which is represented by the following general formula (1): 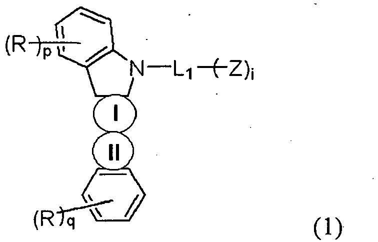 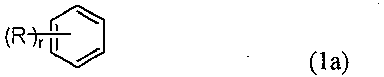 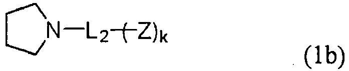 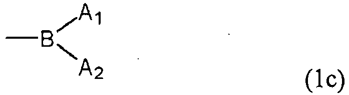 wherein:
a ring I represents an aromatic hydrocarbon ring represented by the formula (1a) to be fused to adjacent rings at arbitrary positions and a ring II represents a heterocycle represented by the formula (1b) to be fused to adjacent rings at arbitrary positions;
L₁ and L₂ each independently represent an i+1-valent or k+1-valent group selected from a substituted or unsubstituted aromatic hydrocarbon group having 6 to 18 carbon atoms, a substituted or unsubstituted aromatic heterocyclic group having 3 to 17 carbon atoms, and a linked aromatic group formed by linking two to six of aromatic rings of the substituted or unsubstituted aromatic hydrocarbon groups and the substituted or unsubstituted aromatic heterocyclic groups, the linked aromatic group may be linear or branched, and the aromatic rings to be linked may be identical to or different from each other;
Z represents a boron-containing group represented by the formula (1c);
Rs each independently represent deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group having 2 to 12 carbon atoms, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, an amide group, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c);
A₁ and A₂ each independently represent hydrogen, deuterium, an alkyl group having 1 to 12 carbon atoms, an alkenyl group having 2 to 12 carbon atoms, an alkynyl group having 2 to 12 carbon atoms, an alkoxyl group having 1 to 12 carbon atoms, chlorine, bromine, fluorine, a substituted or unsubstituted aromatic hydrocarbon group having 6 to 18 carbon atoms, or a substituted or unsubstituted aromatic heterocyclic group having 3 to 17 carbon atoms, or, when A₁ and A₂ each represent an aromatic hydrocarbon group or an aromatic heterocyclic group, A₁ and A₂ may be bonded to adjacent A₁ and A₂ or substituents of A₁ and A₂ to form a ring; and p and q each independently represent an integer of from 0 to 4, r represents an integer of from 0 to 2, and i and k each represent an integer of from 0 to 5, provided that p+q+r+i+k≥1 and when both of i and k represent 0, at least one of Rs represents a boron-containing group represented by the formula (1c), and when p, q, r, i, and k each represent 2 or more, Rs and Zs may be identical to or different from each other.

2. A compound for an organic electroluminescent device according to claim 1, wherein the compound is represented by any one of the general formulae (2) to (5): 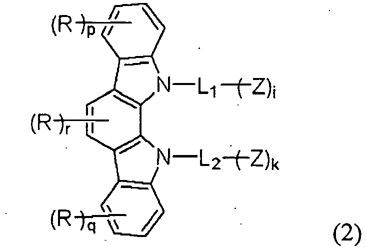 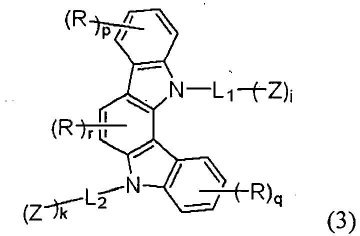 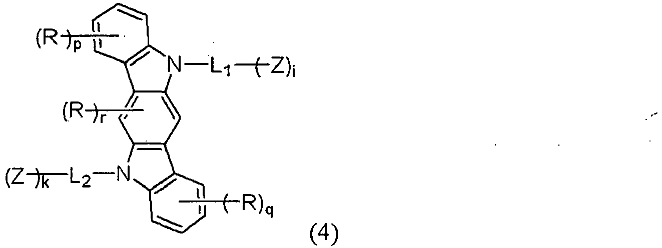 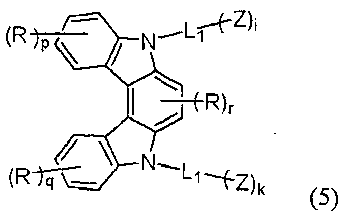 in the general formulae (2) to (5), L₁, L₂, Z, R, p, q, r, i, and k each have the same meaning as that of the general formula (1).

3. A compound for an organic electroluminescent device according to claim 1, wherein: Rs each independently represent deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a dialkylamino group having 2 to 24 carbon atoms, a diarylamino group having 6 to 36 carbon atoms, a diaralkylamino group having 14 to 38 carbon atoms, an acyl group having 2 to 12 carbon atoms, an alkoxycarbonyl group having 2 to 12 carbon atoms, an alkoxyl group having 1 to 12 carbon atoms, an alkylsulfonyl group having 1 to 12 carbon atoms, a haloalkyl group having 1 to 12 carbon atoms, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c); and
A₁ and A₂ each independently represent an alkyl group having 1 to 12 carbon atoms, a substituted or unsubstituted aromatic hydrocarbon group having 6 to 18 carbon atoms, or a substituted or unsubstituted aromatic heterocyclic group having 3 to 17 carbon atoms.

4. A compound for an organic electroluminescent device according to claim 1, wherein i+k is 1 or more and Rs each represent a group except a boron-containing group.

5. A compound for an organic electroluminescent device according to claim 1, wherein A₁ and A₂ each independently represent a substituted or unsubstituted aromatic hydrocarbon group having 6 to 18 carbon atoms, or a substituted or unsubstituted aromatic heterocyclic group having 3 to 17 carbon atoms.

6. An organic electroluminescent device, comprising an organic layer containing a compound for an organic electroluminescent device, which is represented by the following general formula (1): 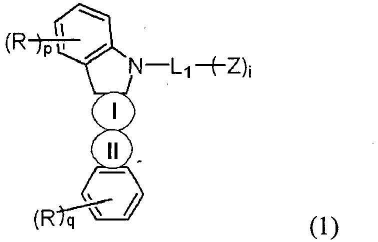 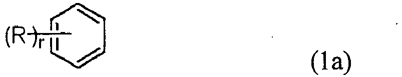 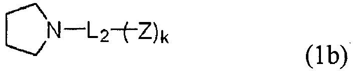 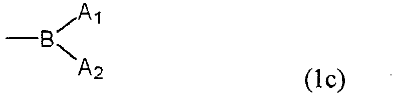 wherein:
a ring I represents an aromatic hydrocarbon ring represented by the formula (la) to be fused to adjacent rings at arbitrary positions and a ring II represents a heterocycle represented by the formula (1b) to be fused to adjacent rings at arbitrary positions;
L₁ and L₂ each independently represent an i+1-valent or k+1-valent group selected from a substituted or unsubstituted aromatic hydrocarbon group having 6 to 18 carbon atoms, a substituted or unsubstituted aromatic heterocyclic group having 3 to 17 carbon atoms, and a linked aromatic group formed by linking two to six of aromatic rings of the substituted or unsubstituted aromatic hydrocarbon groups and the substituted or unsubstituted aromatic heterocyclic groups, the linked aromatic group may be linear or branched, and the aromatic rings to be linked may be identical to or different from each other;
Z represents a boron-containing group represented by the formula (1c);
Rs each independently represent deuterium, an alkyl group having 1 to 12 carbon atoms, an aralkyl group having 7 to 19 carbon atoms, an alkenyl group having 2 to 12 carbon atoms, an alkynyl group having 2 to 12 carbon atoms, a cyano group, a dialkylamino group having 2 to 24 carbon atoms, a diarylamino group having 6 to 36 carbon atoms, a diaralkylamino group having 14 to 38 carbon atoms, an amino group, a nitro group, an acyl group having 2 to 12 carbon atoms, an alkoxycarbonyl group having 2 to 12 carbon atoms, a carboxyl group, an alkoxyl group having 1 to 12 carbon atoms, an alkylsulfonyl group having 1 to 12 carbon atoms, a haloalkyl group having 1 to 12 carbon atoms, a hydroxyl group, an amide group, a phenoxy group, an alkylthio group having 1 to 12 carbon atoms, a substituted or unsubstituted aromatic hydrocarbon group having 6 to 18 carbon atoms, a substituted or unsubstituted aromatic heterocyclic group having 3 to 17 carbon atoms, or a boron-containing group represented by the formula (1c);
A₁ and A₂ each independently represent hydrogen, deuterium, an alkyl group having 1 to 12 carbon atoms, an alkenyl group having 2 to 12 carbon atoms, an alkynyl group having 2 to 12 carbon atoms, an alkoxyl group having 1 to 12 carbon atoms, a hydroxyl group, chlorine, bromine, fluorine, a substituted or unsubstituted aromatic hydrocarbon group having 6 to 18 carbon atoms, or a substituted or unsubstituted aromatic heterocyclic group having 3 to 17 carbon atoms, and A₁ and A₂ may be bonded to adjacent A₁ and A₂ or substituents of A₁ and A₂ to form a ring; and
p and q each independently represent an integer of from 0 to 4, r represents an integer of from 0 to 2, and i and k each represent an integer of from 0 to 5, provided that p+q+r+i+k≥1 and when both of i and k represent 0, at least one of Rs represents a boron-containing group represented by the formula (1c), and when p, q, r, i, and k each represent 2 or more, Rs and Zs may be identical to or different from each other.

7. An organic electroluminescent device according to claim 6, comprising an organic layer containing the compound for an organic electroluminescent device according to any one of claims 1 to 5.

8. An organic electroluminescent device according to claim 6 or 7, wherein the organic layer containing the compound for an organic electroluminescent device comprises at least one layer selected from a light-emitting layer, a hole-transporting layer, a hole-injecting layer, an electron-transporting layer, and an electron-injecting layer.

9. An organic electroluminescent device according to claim 6 or 7, wherein the organic layer containing the compound for an organic electroluminescent device comprises a light-emitting layer, and the light-emitting layer contains a phosphorescent light-emitting dopant and the compound for an organic electroluminescent device as a host material.

## Patentansprüche

1. Eine Verbindung für eine organische Elektrolumineszenzvorrichtung, die durch die folgende allgemeine Formel (1) dargestellt ist: 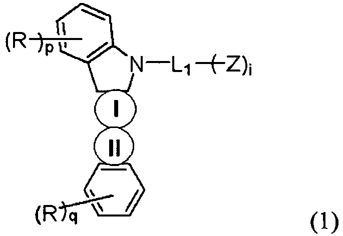 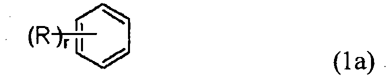 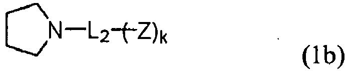 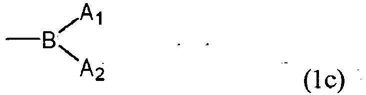 wobei:
ein Ring I einen aromatischen Kohlenwasserstoffring, dargestellt durch die Formel (1a), darstellt, der an beliebigen Positionen an benachbarte Ringe anelliert werden soll, und ein Ring II einen Heterocyclus, dargestellt durch die Formel (1b), darstellt, der an beliebigen Positionen an benachbarte Ringe anelliert werden soll;
L₁ und L₂ jeweils unabhängig eine i+1-wertige oder k+1-wertige Gruppe darstellen,
ausgewählt aus einer substituierten oder unsubstituierten aromatischen Kohlenwasserstoffgruppe mit 6 bis 18 Kohlenstoffatomen, einer substituierten oder
unsubstituierten aromatischen heterocyclischen Gruppe mit 3 bis 17 Kohlenstoffatomen,
und einer verbundenen aromatischen Gruppe, die durch Verbinden von zwei bis sechs aromatischen Ringen der substituierten oder unsubstituierten aromatischen Kohlenwasserstoffgruppen und der substituierten oder unsubstituierten aromatischen heterocyclischen Gruppen gebildet ist, wobei die verbundene aromatische Gruppe geradkettig oder verzweigt sein kann, und die aromatischen Ringe, die verbunden werden sollen, gleich oder voneinander verschieden sein können;
Z eine Bor enthaltende Gruppe mit der Formel (1c) darstellt;
die Reste R jeweils unabhängig Deuterium, eine Alkylgruppe mit 1 bis 12 Kohlenstoffatomen, eine Aralkylgruppe mit 7 bis 19 Kohlenstoffatomen, eine Alkenylgruppe mit 2 bis 12 Kohlenstoffatomen, eine Alkinylgruppe mit 2 bis 12 Kohlenstoffatomen, eine Cyanogruppe, eine Dialkylaminogruppe mit 2 bis 24 Kohlenstoffatomen, eine Diarylaminogruppe mit 6 bis 36 Kohlenstoffatomen, eine Diaralkylaminogruppe mit 14 bis 38 Kohlenstoffatomen, eine Aminogruppe, eine Nitrogruppe, eine Acylgruppe mit 2 bis 12 Kohlenstoffatomen, eine Alkoxycarbonylgruppe mit 2 bis 12 Kohlenstoffatomen, eine Carboxylgruppe, eine Alkoxylgruppe mit 1 bis 12 Kohlenstoffatomen, eine Alkylsulfonylgruppe mit 1 bis 12 Kohlenstoffatomen, eine Halogenalkylgruppe mit 1 bis 12 Kohlenstoffatomen, eine Hydroxylgruppe, eine Amidgruppe, eine Phenoxygruppe, eine Alkylthiogruppe mit 1 bis 12 Kohlenstoffatomen, eine substituierte oder unsubstituierte aromatische Kohlenwasserstoffgruppe mit 6 bis 18 Kohlenstoffatomen, eine substituierte oder
unsubstituierte aromatische heterocyclische Gruppe mit 3 bis 17 Kohlenstoffatomen oder
eine Bor enthaltende Gruppe, dargestellt durch die Formel (1c), darstellen;
A₁ und A₂ jeweils unabhängig Wasserstoff, Deuterium, eine Alkylgruppe mit 1 bis 12 Kohlenstoffatomen, eine Alkenylgruppe mit 2 bis 12 Kohlenstoffatomen, eine Alkinylgruppe mit 2 bis 12 Kohlenstoffatomen, eine Alkoxylgruppe mit 1 bis 12 Kohlenstoffatomen, Chlor, Brom, Fluor, eine substituierte oder unsubstituierte aromatische Kohlenwasserstoffgruppe mit 6 bis 18 Kohlenstoffatomen oder eine substituierte oder unsubstituierte aromatische heterocyclische Gruppe mit 3 bis 17 Kohlenstoffatomen darstellen, oder, wenn A₁ und A₂ jeweils eine aromatische Kohlenwasserstoffgruppe oder eine aromatische heterocyclische. Gruppe darstellen, A₁ und A₂ an benachbarte A₁ und A₂ gebunden sein können oder an Substituenten von A₁ und A₂ gebunden sein können, um einen Ring zu bilden; und
p und q jeweils unabhängig eine ganze Zahl von 0 bis 4 darstellen, r eine ganze Zahl von 0 bis 2 darstellt, und i und k jeweils eine ganze Zahl von 0 bis 5 darstellen, mit der Maßgabe, dass p+q+r+i+k≥1 und wenn i und k beide gleich 0 darstellen, mindestens einer der Reste R eine Bor enthaltende Gruppe, dargestellt durch die Formel (1c), darstellt, und wenn p, q, r, i und k jeweils 2 oder mehr darstellen, die Reste R und Z gleich oder voneinander verschieden sein können.

2. Eine Verbindung für eine organische Elektrolumineszenzvorrichtung gemäß Anspruch 1, wobei die Verbindung durch eine der allgemeinen Formeln (2) bis (5) dargestellt ist: 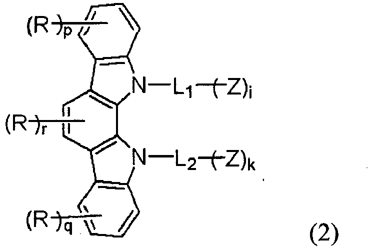 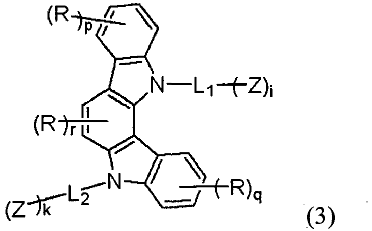 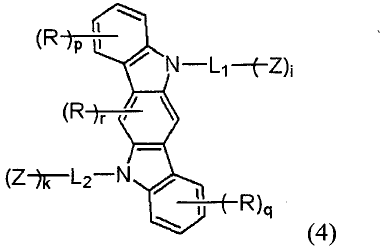 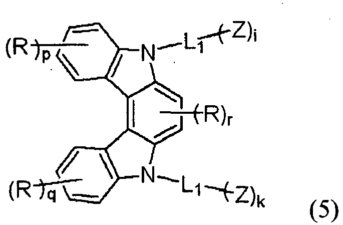 L₁, L₂, Z, R, p, q, r, i und k in den allgemeinen Formeln (2) bis (5) jeweils die gleiche Bedeutung wie in der allgemeinen Formel (1) aufweisen.

3. Eine Verbindung für eine organische Elektrolumineszenzvorrichtung gemäß Anspruch 1, wobei:
die Reste R jeweils unabhängig Deuterium, eine Alkylgruppe mit 1 bis 12 Kohlenstoffatomen, eine Aralkylgruppe mit 7 bis 19 Kohlenstoffatomen, eine Alkenylgruppe mit 2 bis 12 Kohlenstoffatomen, eine Alkinylgruppe mit 2 bis 12 Kohlenstoffatomen, eine Dialkylaminogruppe mit 2 bis 24 Kohlenstoffatomen, eine Diarylaminogruppe mit 6 bis 36 Kohlenstoffatomen, eine Diaralkylaminogruppe mit 14 bis 38 Kohlenstoffatomen, eine Acylgruppe mit 2 bis 12 Kohlenstoffatomen, eine Alkoxycarbonylgruppe mit 2 bis 12 Kohlenstoffatomen, eine Alkoxylgruppe mit 1 bis 12 Kohlenstoffatomen, eine Alkylsulfonylgruppe mit 1 bis 12 Kohlenstoffatomen, eine Halogenalkylgruppe mit 1 bis 12 Kohlenstoffatomen, eine Phenoxygruppe, eine Alkylthiogruppe mit 1 bis 12 Kohlenstoffatomen, eine substituierte oder unsubstituierte aromatische Kohlenwasserstoffgruppe mit 6 bis 18 Kohlenstoffatomen, eine substituierte oder unsubstituierte aromatische heterocyclische Gruppe mit 3 bis 17 Kohlenstoffatomen oder eine Bor enthaltende Gruppe, dargestellt durch die Formel (1c), darstellen; und
A₁ und A₂ jeweils unabhängig eine Alkylgruppe mit 1 bis 12 Kohlenstoffatomen, eine substituierte oder unsubstituierte aromatische Kohlenwasserstoffgruppe mit 6 bis 18 Kohlenstoffatomen oder eine substituierte oder unsubstituierte aromatische heterocyclische Gruppe mit 3 bis 17 Kohlenstoffatomen darstellen.

4. Eine Verbindung für eine organische Elektrolumineszenzvorrichtung gemäß Anspruch 1, wobei i+k gleich 1 oder mehr ist und die Reste R jeweils eine Gruppe außer einer Bor enthaltenden Gruppe darstellen.

5. Eine Verbindung für eine organische Elektrolumineszenzvorrichtung gemäß Anspruch 1, wobei A₁ und A₂ jeweils unabhängig eine substituierte oder unsubstituierte aromatische Kohlenwasserstoffgruppe mit 6 bis 18 Kohlenstoffatomen oder eine substituierte oder unsubstituierte aromatische heterocyclische Gruppe mit 3 bis 17 Kohlenstoffatomen darstellen.

6. Eine organische Elektrolumineszenzvorrichtung, umfassend eine organische Schicht, die eine Verbindung für eine organische Elektrolumineszenzvorrichtung, die durch die folgende allgemeine Formel (1) dargestellt ist, enthält: 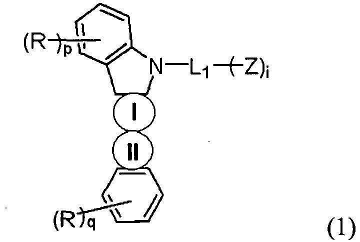 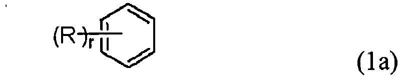 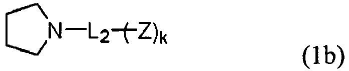 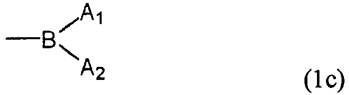 wobei:
ein Ring I einen aromatischen Kohlenwasserstoffring, dargestellt durch die Formel (1a), darstellt, der an beliebigen Positionen an benachbarte Ringe anelliert werden soll, und ein Ring II einen Heterocyclus, dargestellt durch die Formel (1b), darstellt, der an beliebigen Positionen an benachbarte Ringe anelliert werden soll;
L₁ und L₂ jeweils unabhängig eine i+1-wertige oder k+1-wertige Gruppe darstellen, ausgewählt aus einer substituierten oder unsubstituierten aromatischen Kohlenwasserstoffgruppe mit 6 bis 18 Kohlenstoffatomen, einer substituierten oder unsubstituierten aromatischen heterocyclischen Gruppe mit 3 bis 17 Kohlenstoffatomen, und einer verbundenen aromatischen Gruppe, die durch Verbinden von zwei bis sechs aromatischen Ringen der substituierten oder unsubstituierten aromatischen Kohlenwasserstoffgruppen und der substituierten oder unsubstituierten aromatischen heterocyclischen Gruppen gebildet ist, wobei die verbundene aromatische Gruppe geradkettig oder verzweigt sein kann, und die aromatischen Ringe, die verbunden werden sollen, gleich oder voneinander verschieden sein können;
Z eine Bor enthaltende Gruppe mit der Formel (1c) darstellt;
die Reste R jeweils unabhängig Deuterium, eine Alkylgruppe mit 1 bis 12 Kohlenstoffatomen, eine Aralkylgruppe mit 7 bis 19 Kohlenstoffatomen, eine Alkenylgruppe mit 2 bis 12 Kohlenstoffatomen, eine Alkinylgruppe mit 2 bis 12 Kohlenstoffatomen, eine Cyanogruppe, eine Dialkylaminogruppe mit 2 bis 24 Kohlenstoffatomen, eine Diarylaminogruppe mit 6 bis 36 Kohlenstoffatomen, eine Diaralkylaminogruppe mit 14 bis 38 Kohlenstoffatomen, eine Aminogruppe, eine Nitrogruppe, eine Acylgruppe mit 2 bis 12 Kohlenstoffatomen, eine Alkoxycarbonylgruppe mit 2 bis 12 Kohlenstoffatomen, eine. Carboxylgruppe, eine Alkoxylgruppe mit 1 bis 12 Kohlenstoffatomen, eine Alkylsulfonylgruppe mit 1 bis 12 Kohlenstoffatomen, eine Halogenalkylgruppe mit 1 bis 12 Kohlenstoffatomen, eine Hydroxylgruppe, eine Amidgruppe, eine Phenoxygruppe, eine Alkylthiogruppe mit 1 bis 12 Kohlenstoffatomen, eine substituierte oder unsubstituierte aromatische Kohlenwasserstoffgruppe mit 6 bis 18 Kohlenstoffatomen, eine substituierte oder unsubstituierte aromatische heterocyclische Gruppe mit 3 bis 17 Kohlenstoffatomen oder eine Bor enthaltende Gruppe, dargestellt durch die Formel (1c), darstellen;
A₁ und A₂ jeweils unabhängig Wasserstoff, Deuterium, eine Alkylgruppe mit 1 bis 12 Kohlenstoffatomen, eine Alkenylgruppe mit 2 bis 12 Kohlenstoffatomen, eine Alkinylgruppe mit 2 bis 12 Kohlenstoffatomen, eine Alkoxylgruppe mit 1 bis 12 Kohlenstoffatomen, eine Hydroxylgruppe, Chlor, Brom, Fluor, eine substituierte oder unsubstituierte aromatische Kohlenwasserstoffgruppe mit 6 bis 18 Kohlenstoffatomen oder eine substituierte oder unsubstituierte aromatische heterocyclische Gruppe mit 3 bis 17 Kohlenstoffatomen darstellen, und A₁ und A₂ an benachbarte A₁ und A₂ gebunden sein können oder an Substituenten von A₁ und A₂ gebunden sein können, um einen Ring zu bilden; und
p und q jeweils unabhängig eine ganze Zahl von 0 bis 4 darstellen, r eine ganze Zahl von 0 bis 2 darstellt, und i und k jeweils eine ganze Zahl von 0 bis 5 darstellen, mit der Maßgabe, dass p+q+r+i+k≥1 und wenn i und k beide gleich 0 darstellen, mindestens einer der Reste R eine Bor enthaltende Gruppe, dargestellt durch die Formel (1c), darstellt, und wenn p, q, r, i, und k jeweils 2 oder mehr darstellen, die Reste R und Z gleich oder voneinander verschieden sein können.

7. Eine organische Elektrolumineszenzvorrichtung gemäß Anspruch 6, umfassend eine organische Schicht, die die Verbindung für eine organische Elektrolumineszenzvorrichtung gemäß einem der Ansprüche 1 bis 5 enthält.

8. Eine organische Elektrolumineszenzvorrichtung gemäß Anspruch 6 oder 7, wobei die organische Schicht, die die Verbindung für eine organische Elektrolumineszenzvorrichtung enthält, mindestens eine Schicht, ausgewählt aus einer Licht-emittierenden Schicht, einer Lochtransportschicht, einer Lochinjektionsschicht, einer Elektronentransportschicht und einer Elektroneninjektionsschicht umfasst.

9. Eine organische Elektrolumineszenzvorrichtung gemäß Anspruch 6 oder 7, wobei die organische Schicht, die die Verbindung für eine organische Elektrolumineszenzvorrichtung enthält, eine Licht-emittierende Schicht umfasst, und die Licht-emittierende Schicht einen phosphoreszenten Licht-emittierenden Dotierstoff und die Verbindung für eine organische Elektrolumineszenzvorrichtung als ein Gastmaterial enthält.

## Revendications

1. Composé pour un dispositif électroluminescent organique, qui est représenté par la formule générale (1): 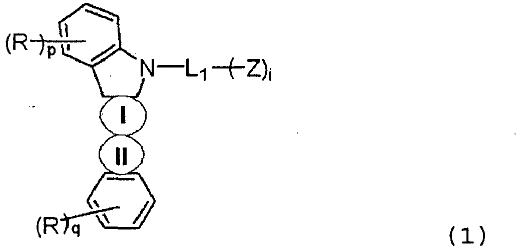 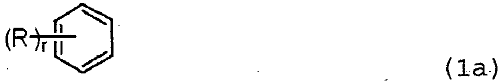 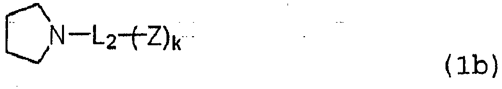 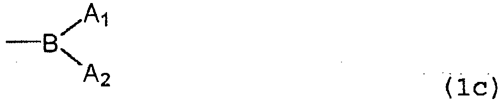 où:
le cycle I représente un cycle hydrocarboné aromatique représenté par la formule (la) devant être condensé à des cycles adjacents en des positions arbitraires et le cycle II représente un hétérocycle représenté par la formule (1b) devant être condensé à des cycles adjacents en des positions arbitraires;
chacun de L₁ et L₂ représente indépendamment un groupe de valence i+1 ou de valence k+1 choisi parmi un groupe hydrocarboné aromatique substitué ou non substitué comportant 6 à 18 atomes de carbone, un groupe hétérocyclique aromatique substitué ou
non substitué comportant 3 à 17 atomes de carbone, et un groupe aromatique lié formé par liaison de deux à six cycles aromatiques des groupes hydrocarbonés aromatiques substitués ou non substitués et des groupes hétérocycliques aromatiques substitués ou non substitués, le groupe aromatique lié pouvant être linéaire ou ramifié, et les cycles aromatiques devant être liés pouvant être identiques ou différents;
Z représente un groupe contenant du bore représenté par la formule (1c);
chaque R représente indépendamment le deutérium, un groupe alkyle comportant 1 à 12 atome(s) de carbone, un groupe aralkyle comportant 7 à 19 atomes de carbone, un groupe alcényle comportant 2 à 12 atomes de carbone, un groupe alcynyle comportant 2 à 12 atomes de carbone, un groupe cyano, un groupe dialkylamino comportant 2 à 24 atomes de carbone, un groupe diarylamino comportant 6 à 36 atomes de carbone, un groupe diaralkylamino comportant 14 à 38 atomes de carbone, un groupe amino, un groupe nitro, un groupe acyle comportant 2 à 12 atomes de carbone, un groupe alcoxycarbonyle comportant 2 à 12 atomes de carbone, un groupe carboxyle, un groupe alcoxyl comportant 1 à 12 atome(s) de carbone, un groupe alkylsulfonyle comportant 1 à 12 atome(s) de carbone, un groupe halogénoalkyle comportant 1 à 12 atome(s) de carbone, un groupe hydroxyle, un groupe amide, un groupe phénoxy, un groupe alkylthio comportant 1 à 12 atome(s) de carbone, un groupe hydrocarboné aromatique substitué ou non substitué comportant 6 à 18 atomes de carbone, un groupe hétérocyclique aromatique substitué ou non substitué comportant 3 à 17 atomes de carbone, ou un groupe contenant du bore représenté par la formule (1c);
chacun de A₁ et A₂ représente indépendamment l'hydrogène, le deutérium, un groupe alkyle comportant 1 à 12 atome(s) de carbone, un groupe alcényle comportant 2 à 12 atomes de carbone, un groupe alcynyle comportant 2 à 12 atomes de carbone, un groupe alcoxyl comportant 1 à 12 atome(s) de carbone, le chlore, le brome, le fluor, un groupe hydrocarboné aromatique substitué ou non substitué comportant 6 à 18 atomes de carbone, ou un groupe hétérocyclique aromatique substitué ou non substitué comportant 3 à 17 atomes de carbone, ou bien, quand chacun de A₁ et A₂ représente un groupe hydrocarboné aromatique ou un groupe hétérocyclique aromatique, A₁ et A₂ peuvent être liés à des A₁ et A₂ adjacents ou des substituants de A₁ et A₂ pour former un cycle; et
chacun de p et q représente indépendamment un entier de 0 à 4, r représente un entier de 0 à 2, et chacun de i et k représente un entier de 0 à 5, sous réserve que p+q+r+i+k ≥ 1, et quand i et k valent tous deux 0, au moins l'un des R représente un groupe contenant du bore représenté par la formule (1c), et quand chacun de p, q, r, i et k vaut 2 ou plus, les R et Z puissent être identiques ou différents.

2. Composé pour un dispositif électroluminescent organique selon la revendication 1, lequel composé est représenté par l'une quelconque des formules générales (2) à (5): 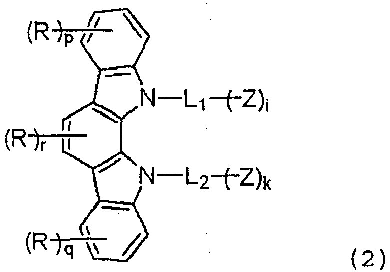 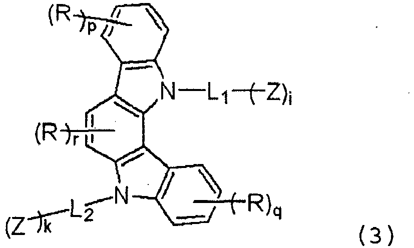 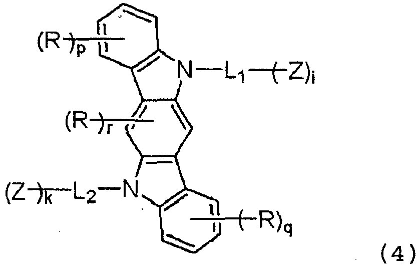 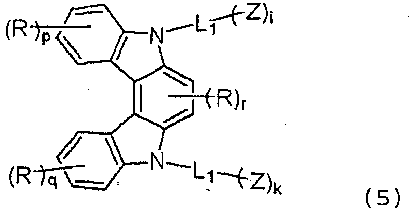 dans les formules générales (2) à (5), chacun de L₁, L₂, Z, R, p, q, r, i et k a la même signification que celle à propos de la formule générale (1).

3. Composé pour un dispositif électroluminescent organique selon la revendication 1, dans lequel:
chaque R représente indépendamment le deutérium, un groupe alkyle comportant 1 à 12 atome(s) de carbone, un groupe aralkyle comportant 7 à 19 atomes de carbone, un groupe alcényle comportant 2 à 12 atomes de carbone, un groupe alcynyle comportant 2 à 12 atomes de carbone, un groupe dialkylamino comportant 2 à 24 atomes de carbone, un groupe diarylamino comportant 6 à 36 atomes de carbone, un groupe diaralkylamino comportant 14 à 38 atomes de carbone, un groupe acyle comportant 2 à 12 atomes de carbone, un groupe alcoxycarbonyle comportant 2 à 12 atomes de carbone, un groupe alcoxyl comportant 1 à 12 atome(s) de carbone, un groupe alkylsulfonyle comportant 1 à 12 atome(s) de carbone, un groupe halogénoalkyle comportant 1 à 12 atome(s) de carbone, un groupe phénoxy, un groupe alkylthio comportant 1 à 12 atome(s) de carbone, un groupe hydrocarboné aromatique substitué ou non substitué comportant 6 à 18 atomes de carbone, un groupe hétérocyclique aromatique substitué ou non substitué comportant 3 à 17 atomes de carbone, ou un groupe contenant du bore représenté par la formule (1c); et
chacun de A₁ et A₂ représente indépendamment un groupe alkyle comportant 1 à 12 atome(s) de carbone, un groupe hydrocarboné aromatique substitué ou non substitué comportant 6 à 18 atomes de carbone, ou un groupe hétérocyclique aromatique substitué ou non substitué comportant 3 à 17 atomes de carbone.

4. Composé pour un dispositif électroluminescent organique selon la revendication 1, dans lequel i+k vaut 1 ou plus et chaque R représente un groupe à l'exception d'un groupe contenant du bore.

5. Composé pour un dispositif électroluminescent organique selon la revendication 1, dans lequel chacun de A₁ et A₂ représente indépendamment un groupe hydrocarboné aromatique substitué ou non substitué comportant 6 à 18 atomes de carbone, ou un groupe hétérocyclique aromatique substitué ou non substitué comportant 3 à 17 atomes de carbone.

6. Dispositif électroluminescent organique comprenant une couche organique contenant un composé pour un dispositif électroluminescent organique qui est représenté par la formule générale (1) suivante: 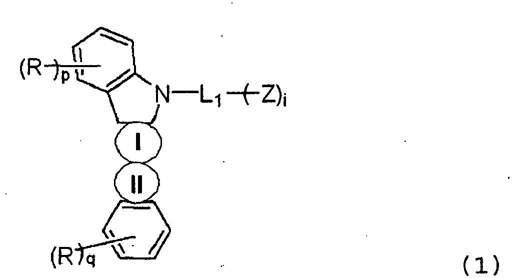 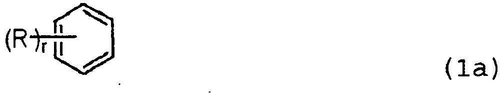 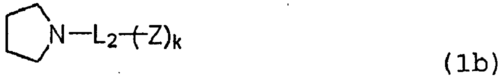 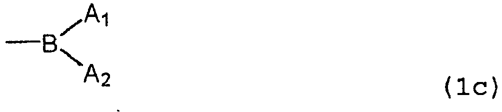 où:
le cycle I représente un cycle hydrocarboné aromatique représenté par la formule (1a) devant être condensé à des cycles adjacents en des positions arbitraires et le cycle II représente un hétérocycle représenté par la formule (1b) devant être condensé à des cycles adjacents en des positions arbitraires;
chacun de L₁ et L₂ représente indépendamment un groupe de valence i+1 ou de valence k+1 choisi parmi un groupe hydrocarboné aromatique substitué ou non substitué comportant 6 à 18 atomes de carbone, un groupe hétérocyclique aromatique substitué ou non substitué comportant 3 à 17 atomes de carbone, et un groupe aromatique lié formé par liaison de deux à six cycles aromatiques des groupes hydrocarbonés aromatiques substitués ou non substitués et des groupes hétérocycliques aromatiques substitués ou non substitués, le groupe aromatique lié pouvant être linéaire ou ramifié, et les cycles aromatiques devant être liés pouvant être identiques ou différents;
Z représente un groupe contenant du bore représenté par la formule (1c);
chaque R représente indépendamment le deutérium, un groupe alkyle comportant 1 à 12 atome(s) de carbone, un groupe aralkyle comportant 7 à 19 atomes de carbone, un groupe alcényle comportant 2 à 12 atomes de carbone, un groupe alcynyle comportant 2 à 12 atomes de carbone, un groupe cyano, un groupe dialkylamino comportant 2 à 24 atomes de carbone, un groupe diarylamino comportant 6 à 36 atomes de carbone, un groupe diaralkylamino comportant 14 à 38 atomes de carbone, un groupe amino, un groupe nitro, un groupe acyle comportant 2 à 12 atomes de carbone, un groupe alcoxycarbonyle comportant 2 à 12 atomes de carbone, un groupe carboxyle, un groupe alcoxyl comportant 1 à 12 atome(s) de carbone, un groupe alkylsulfonyle comportant 1 à 12 atome(s) de carbone, un groupe halogénoalkyle comportant 1 à 12 atome(s) de carbone, un groupe hydroxyle, un groupe amide, un groupe phénoxy, un groupe alkylthio comportant 1 à 12 atome(s) de carbone, un groupe hydrocarboné aromatique substitué ou non substitué comportant 6 à 18 atomes de carbone, un groupe hétérocyclique aromatique substitué ou non substitué comportant 3 à 17 atomes de carbone, ou un groupe contenant du bore représenté par la formule (1c);
chacun de A₁ et A₂ représente indépendamment l'hydrogène, le deutérium, un groupe alkyle comportant 1 à 12 atome(s) de carbone, un groupe alcényle comportant 2 à 12 atomes de carbone, un groupe alcynyle comportant 2 à 12 atomes de carbone, un groupe alcoxyl comportant 1 à 12 atome(s) de carbone, un groupe hydroxyle, le chlore, le brome, le fluor, un groupe hydrocarboné aromatique substitué ou non substitué comportant 6 à 18 atomes de carbone, ou un groupe hétérocyclique aromatique substitué ou non substitué comportant 3 à 17 atomes de carbone, et A₁ et A₂ peuvent être liés à des A₁ et A₂ adjacents ou des substituants de A₁ et A₂ pour former un cycle; et
chacun de p et q représente indépendamment un entier de 0 à 4, r représente un entier de 0 à 2, et chacun de i et k représente un entier de 0 à 5, sous réserve que p+q+r+i+k ≥ 1, et quand i et k valent tous deux 0, au moins l'un des R représente un groupe contenant du bore représenté par la formule (1c), et quand chacun de p, q, r, i et k vaut 2 ou plus, les R et Z puissent être identiques ou différents.

7. Dispositif électroluminescent organique selon la revendication 6, comprenant une couche organique comprenant un composé pour un dispositif électroluminescent organique selon l'une quelconque des revendications 1 à 5.

8. Dispositif électroluminescent organique selon la revendication 6 ou 7, dans lequel la couche organique contenant le composé pour un dispositif électroluminescent organique comprend au moins une couche choisie parmi une couche luminescente, une couche de transport de trous, une couche d'injection de trous, une couche de transport d'électrons, et une couche d'injection d'électrons.

9. Dispositif électroluminescent organique selon la revendication 6 ou 7, dans lequel la couche organique contenant le composé pour un dispositif électroluminescent organique comprend une couche luminescente, et la couche luminescente contient un dopant luminescent phosphorescent et le composé pour un dispositif électroluminescent organique en tant que matériau hôte.
